# FASCICULE DE BREVET EUROPEEN

(11) **EP 2 226 678 B1**
(45) Date de publication et mention de la délivrance du brevet: **03.01.2018**
(21) Numéro de dépôt: 10155088.7
(22) Date de dépôt: 01.03.2010
(51) Int. Cl.: G03F 7/00

(54) **Procédé de fabrication d'un moule pour la lithographie par nano-impression**
Verfahren zur Herstellung einer Nanoimprintform
Process for fabricating a mould for nanoimprint lithography

(30) Priorité: 03.03.2009 FR 0951335
(43) Date de publication de la demande: 08.09.2010
(73) Titulaire: Commissariat à l'Énergie Atomique et aux Énergies Alternatives, 75015 Paris (FR)
(72) Inventeur: Landis, Stéfan, 38500 Voiron (FR)
(74) Mandataire: Ilgart, Jean-Christophe

(56) Documents cités:
- EP-A2- 1 333 324
- WO-A-2004/022478
- WO-A-2008/138361
- FR-A- 2 893 018
- US-A1- 2002 075 554
- US-A1- 2006 021 967
- US-A1- 2006 186 084
- US-A1- 2007 049 028
- US-B1- 6 544 863
- US-B1- 7 141 866

## Description

### DOMAINE TECHNIQUE ÉTAT DE LA TECHNIQUE ANTÉRIEURE

L'invention concerne le domaine dit de la nano-impression, technique de lithographie qui permet de produire une empreinte de type positif en pressant un moule, comportant des motifs de type négatif, pouvant avoir des dimensions micrométriques et/ou nanométriques, dans une couche de résine déposée sur le substrat à structurer.

On peut ainsi réaliser des motifs de quelques nanomètres à plusieurs microns de largeur dans une résine ou un polymère et ensuite les transférer dans un substrat.

Cette technique permet de former rapidement, économiquement et de façon fiable de nombreuses structures à partir d'un moule ; l'utilisation du moule ne nécessite de ne mettre en oeuvre qu'une seule fois les techniques coûteuses en temps et/ou en argent qui sont seules à permettre l'obtention de structures de résolutions nanométriques voulues.

Deux approches sont actuellement possibles pour réaliser une lithographie par Nano-impression :
- l'impression thermique qui consiste à chauffer un polymère au delà de sa température de transition vitreuse et à le mettre en forme avec un moule, généralement en silicium ou en nickel.
- l'impression assistée par UV. Dans ce cas un moule transparent, par exemple en quartz, est pressé dans un monomère ou un pré-polymère réticulé par l'exposition UV durant l'application du moule. Cette technique connaît actuellement un important développement du fait de la possibilité d'alignement entre différents niveaux imprimés avec un moule transparent.

La fabrication des moules est une étape critique puisque la résolution, la durée de vie du moule, le taux de production en nano-impression et en nano-moulage et la rentabilité dépendent largement de la qualité et du coût du moule utilisé.

Les motifs à imprimer, en relief sur la surface d'un moule, sont obtenus :
- soit par lithographie électronique et gravure ionique réactive,
- soit par duplication d'un autre moule préfabriqué (master).

La lithographie électronique permet de réaliser un moule avec un faisceau d'électrons focalisé sur une couche de résine sensible aux électrons. On peut alors modifier sélectivement les propriétés physico-chimiques de la résine. Ce faisceau est piloté par un champ électromagnétique sur un champ d'insolation limité. Par conséquent tout type de forme peut alors être créé. En déplaçant mécaniquement l'échantillon d'un champ à un autre avec une haute précision, des motifs couvrant une grande surface ou une plaquette entière peuvent être dessinés.

Tenant compte des performances des systèmes de lithographie électronique, de l'interaction électrons-résine/substrat et des propriétés de la résine utilisées, la taille minimale qui peut être obtenue est typiquement de 20 à 50 nm pour des motifs denses (réseaux de lignes ou de plots ou de trous) et peut atteindre 6 à 10 nm pour de motifs dits isolés, par exemple des lignes. Pour définir des structures de taille encore plus petites, un faisceau d'électrons de plus haute énergie peut être utilisé, comme décrit par F.Carcenac et al. Dans Microelectron. Eng. 53, p. 163 (2000).

Le procédé de lithographie électronique, par exemple du type dit « e-beam », est généralement utilisé pour fabriquer des moules avec une très haute résolution. En effet les techniques de lithographie optique (lithographie 193 nm en immersion) ne permettent pas de réaliser des motifs avec une résolution inférieure à 30 nm.

Si la lithographie électronique permet d'atteindre de très hautes résolutions, elle présente toutefois plusieurs limitations majeures :
- La vitesse d'écriture de la résine (et donc la vitesse et le coût de formation du masque de nano-impression) par un faisceau électronique est usuellement limitée à quelques 10⁻⁴ cm²/s pour l'écriture avec les équipements capables d'atteindre les plus hautes résolutions (inférieures à 10 nm) et de l'ordre de quelques cm²/s pour les technologies multibeam ou faisceaux formés ou par projection (mais la résolution est alors limitée à 30 nm).
- La résolution pouvant être atteinte pour des formes quelconques est classiquement supérieure à 20 nm. Les résolutions inférieures à 10 nm ne sont généralement atteintes que dans des cas de lithographie ultime très simples de lignes ou plots isolés ou très peu denses, c'est-à-dire avec une distance de séparation avec son plus proche voisin 3 ou 4 fois plus importante (voire plus) que la taille du motif lui-même.
- Le coût élevé d'un tel procédé de lithographie électronique. En effet les équipements nécessaires pour faire cette lithographie ultime sont très complexes et très couteux. Par ailleurs les vitesses d'écriture étant au moins 2 à 3 ordres de grandeurs plus lentes que pour la lithographie optique, cela implique que le coût pour réaliser un moule de grande résolution présentant une grande surface active (largement supérieures à plusieurs cm2) est alors excessivement élevé. Or un moule de nano-impression est d'autant plus intéressant que la surface est importante.
- Les motifs de type ultime (<10 nm) ainsi formés ont des géométries de types 2D. La lithographie électronique permet à la fois de définir des motifs de type 2D, chaque motif ayant la même profondeur, avec des résines dites à seuil ou de types 3D (avec une profondeur variable selon les motifs) avec des résines dites à niveaux de gris. Néanmoins il n'est pas possible de combiner actuellement à la fois les capacités résolvantes ultimes de la lithographie électronique avec sa capacité à former des motifs de types 3D.

La présente invention a pour but de proposer une solution technique à toutes ces limitations.

Un but de l'invention est notamment de réaliser des moules en 3 dimensions sans pour autant utiliser un enchainement d'étapes de lithographie-gravure nécessaires avec les procédés classiques pour réaliser un moule avec plusieurs altitudes (ce terme étant pris au sens de hauteurs et/ou profondeurs).

Le document US 2006/186084 décrit un réseau de motifs de nano-lignes avec un écart qui varie spatialement.

Le document US 2007/49028 décrit des techniques de lithographie par nano-impression en vue d'une utilisation dans la fabrication d'un dispositif semi-conducteur.

Le document US 7141866 décrit un appareil pour la lithographie par impression.

Le document EP1333324 décrit un canton pour une impression nanométrique.

### EXPOSÉ DE L'INVENTION

L'invention concerne d'abord un procédé selon la revendication 1.

Ce procédé permet de former un moule de nano-impression. Ce moule permet de réaliser, en impression dans un matériau tel qu'une résine par exemple, des réseaux denses de lignes qui suivent des contours définis par les tranchées.

Les couches alternées peuvent être déposées dans les tranchées de sorte que l'ensemble des couches déposées comporte au moins deux parties symétriques par rapport à un plan passant au milieu des tranchées et perpendiculaire au plan du substrat et au fond es tranchées.

Dans un procédé selon l'invention, les couches alternées peuvent être réalisées par épitaxie.

Si la gravure sélective permet en outre de graver au moins une partie du substrat, de part et d'autre de la topologie, les premiers motifs sont alors saillants par rapport à la surface du substrat. Par exemple, le deuxième matériau est préférentiellement gravé à la même vitesse que le substrat. Ce deuxième matériau peut d'ailleurs être identique à celui du substrat.

En variante, la gravure gravant préférentiellement le deuxième matériau, le sommet des premiers motifs est, après gravure sélective, d'un niveau sensiblement égal à celui de la surface du substrat.

En variante encore, le procédé comporte :
- avant l'étape c), une gravure anisotrope du premier et du deuxième type de matériau, ce qui permet d'amener les deux niveaux des premier et deuxième matériaux à un niveau inférieur à celui du sommet du substrat,
- puis une gravure sélective du deuxième matériau, le sommet des premiers motifs étant, après gravure sélective, d'un niveau inférieur à celui de la surface du substrat.

Un matériau limitant ou inhibant le dépôt des couches conformes alternées parallèlement au fond des tranchées peut d'ailleurs être présent en fond des tranchées. C'est par exemple un oxyde. Les couches alternées réalisées dans les tranchées sont, après un éventuel polissage de surface, uniquement perpendiculaires à la surface du fond des tranchées.

Dans un procédé selon l'invention le substrat peut être de type SOI; une éventuelle couche de matériau limitant ou inhibant le dépôt des couches alternées, présente en fond des tranchées, peut alors être obtenue en gravant la couche superficielle de matériau semi-conducteur du SOI jusqu'à la couche enterrée de matériau isolant.

Alternativement, la ou les couches de matériau limitant ou inhibant le dépôt des couches conformes alternées peuvent être formées par dépôt.

Selon une variante, le matériau limitant ou inhibant le dépôt des couches conformes alternées peut être de plus présent sur le sommet du substrat (il est alors obtenu par exemple par dépôt ou par croissance), avant le dépôt des couches alternée et éliminé après le dépôt des couches alternées. Les couches alternées ne sont alors formées que dans les tranchées et sont uniquement déposées de façon perpendiculaire à la surface du fond des tranchées.

La formation du matériau limitant ou inhibant le dépôt des couches alternées sur le fond des tranchées et le sommet du substrat peut comporter le dépôt d'une couche de matériau dit « spacer ».

Par exemple, ce matériau « spacer » est déposé sur l'ensemble composé du sommet du substrat, des flancs et fonds des tranchées, puis gravé de manière anisotrope, de manière à laisser du matériau spacer uniquement suivant les flancs des tranchées.

Ensuite, il peut y avoir formation de la couche limitant ou inhibant le dépôt, par dépôt ou par réaction sur le fond des tranchées et le sommet du substrat.

Une partie des couches alternées peut être formée sur le sommet du substrat, celles-ci étant alors déposées au moins suivant les flancs des tranchées et autour de chaque tranchée, sur le sommet du substrat, un amincissement, par exemple par technique chimique ou mécanique (polissage) ou mécano chimique, étant effectué ultérieurement de façon à mettre à nu le sommet du substrat.

Dans un procédé selon l'invention, si certaines tranchées ne sont pas entièrement remplies par les couches alternées, il est possible de procéder en outre, par exemple avant un éventuel polissage de la surface libre, au dépôt d'une couche de matériau de remplissage. Ce matériau de remplissage est avantageusement du même type qu'au moins un des types de matériaux utilisés pour les couches alternées, il est préférentiellement différent de celui de la dernière couche déposée. Le matériau de remplissage remplit alors les parties des tranchées non remplies par les couches, ce qui permet de retrouver une planéité partielle.

Il peut également être déposé et sur le sommet du substrat ou sur les couches alternées présente sur le sommet du substrat, la mise a nu du champ du substrat étant faite par amincissement, par exemple par technique chimique ou mécanique (polissage) ou mécano chimique.

Avantageusement, le matériau de remplissage peut être gravé sélectivement par rapport à la dernière couche alternée déposée.

Le nombre de couches alternées déposées peut être tel que :
- la dernière couche déposée peut être gravée sélectivement par rapport au substrat,
- le matériau de remplissage est dans le même matériau que le substrat.

La gravure sélective mise en oeuvre dans le cadre de l'invention peut être une gravure partielle du deuxième matériau, le fond des deuxièmes motifs étant alors composé du deuxième matériau, gravé préférentiellement par rapport au premier.

L'invention concerne de plus un dispositif selon la revendication 12.

Les premiers motifs peuvent être saillants par rapport à ladite surface du substrat et en un matériau différent de celui du substrat.

Le premier niveau peut être sensiblement voisin de ladite surface du substrat.

Le premier niveau peut être inférieur à ladite surface du substrat.

Dans un procédé ou un dispositif selon l'invention, selon un mode de réalisation particulier, les deuxièmes motifs sont en un matériau dont la vitesse de gravure varie d'un deuxième motif à un autre deuxième motif. Ceci résulte, après gravure, en la formation de deuxièmes motifs avec au moins deux niveaux différents ou en des deuxièmes motifs, par exemple des nano-tranchées, dont la profondeur ou le niveau varie dans la tranchée dans laquelle ils sont réalisés.

Par exemple le deuxième matériau formant les couches alternées peut présenter une variation de composition, en particulier de stoechiométrie. Par exemple, au moins deux couches impaires présentent des différences de composition entre elles, bien que relevant de la même composition. Ces couches de compositions différentes ont alors des vitesses de gravure différentes, ce qui conduit, après gravure, à former des motifs avec autant de niveaux que de compositions différentes utilisées dans les couches alternées.

Les différences de vitesses de gravure entre deux différentes couches alternées sont de préférence telles que les variations des niveaux des deuxièmes motifs (ou des profondeurs des nanotranchées), séparant deux premiers motifs, soient optimisées pour réduire les inhomogénéités d'épaisseur résiduelle de matériau d'impression, présentes entre un substrat à lithographier et le moule de nano-impression selon l'invention, lors de l'utilisation de ce dernier.

Par exemple le premier matériau est du Si, le deuxième matériau est en SiGeₓ(x > 15%), et deux couches de deuxième matériau ont des compositions SiGeₓ₁ et SiGeₓ₂, avec x1 ≠ x2 et, de préférence, x1>15% et x2>15%.

En variante, les matériaux composant l'alternance de couches alternées sont choisis parmi Si, SiO2, HfO2, Si3N4, ZrO; par exemple les couples de matériaux retenus pour le premier matériau et le deuxième matériau peuvent être Si/SiO2, ou le couple HfO2/SiO2, ou le couple SiO2/Si3N4, ou le couple ZrO2/SiO2 ou encore des couples de matériaux métalliques.

Selon un mode de réalisation particulier d'un procédé ou d'un dispositif selon l'invention, le substrat peut être dans un des matériaux du couple de matériaux composant les couches alternées.

Dans un procédé ou un dispositif selon l'invention, l'un et/ou l'autre des deux matériaux composant les couches alternées peut être amorphe ou monocristallin ou être poly-cristallin.

Dans un procédé ou un dispositif selon l'invention, les couches alternées peuvent avoir une épaisseur inférieure à 10 nm ou comprise entre 1 nm et 10 nm ou 20 nm.

Un dispositif selon l'invention et/ou fabriqué selon un procédé selon l'invention, peut être utilisé comme moule pour produire des motifs par nano-impression dans une couche de polymère recouvrant un substrat « produit », ou comme négatif de façon à former des moules de Nano-Impression.

Il est aussi possible d'ajouter, suite au procédé selon l'invention, des motifs par lithographie électronique de façon à obtenir un moule complexe. L'usage d'un procédé selon l'invention permet alors de diminuer les besoins en lithographie électronique par masque.

### BRÈVE DESCRIPTION DES DESSINS

Les figures 1A-1E illustrent divers dispositifs réalisés selon l'invention,
Les figures 2A-2E illustrent divers procédés de formation de moules de nano-impression selon l'invention.
Les figures 3A - 3G illustrent des étapes d'un premier procédé non couvert par les revendications.
Les figures 4A - 4E illustrent des étapes d'un deuxième procédé selon l'invention, une couche de matériau inhibant le dépôt des couches conformes étant présente sur une des surfaces.
Les figures 5A - 5F illustrent des étapes d'un troisième procédé selon l'invention, des couches de matériau inhibant le dépôt des couches conformes étant présentes sur le champ de la plaquette et en fond de ligne.
Les figures 6A - 6D illustrent un procédé d'utilisation de moules de nano-impression ainsi que le phénomène dit de l'épaisseur résiduelle.
Les figures 7A - 7C illustrent un mode de réalisation dans lequel un des types de matériau alterné dans la couche composite présente une variation de composition d'une couche comportant ce matériau à l'autre.
Les figures 8A - 8F sont des exemples comparatifs de formes d'impressions réalisées dans une résine en fonction du moule employé.
La figure 9 illustre une coupe d'un dispositif obtenu suivant l'un des procédés suivant l'invention, après l'étape de gravure sélective.
Les figures 10 et 11 illustrent différents résultats de procédés suivant l'invention, respectivement dans une tranchée en spirale, et dans des tranchées formées par un réseau de lignes. Les motifs alternés séparés par des nanotranchées ont alors un dessin global suivant la forme initiale de la tranchée.
La figure 12 illustre le résultat obtenu sur une couche déformable après utilisation d'un moule de nano-impression obtenu suivant l'invention et comprenant une tranchée circulaire.

### EXPOSÉ DÉTAILLÉ DE MODES DE RÉALISATION PARTICULIERS

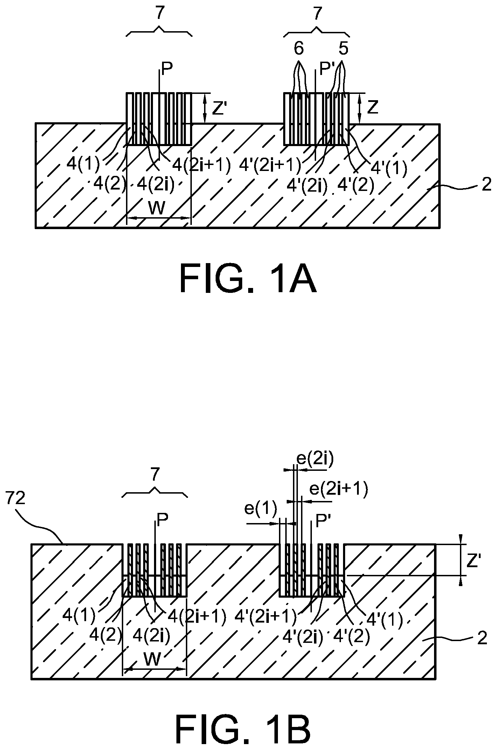

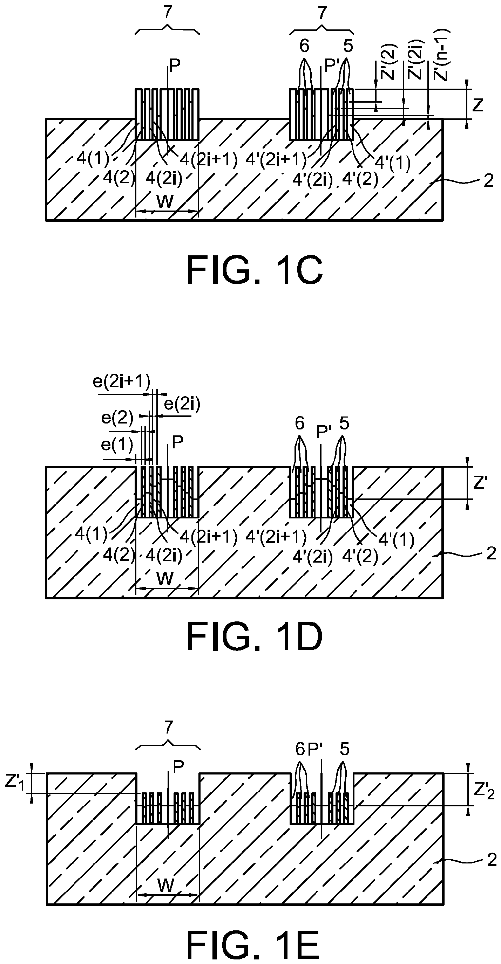

Des modes de réalisation de l'invention sont détaillés ci-dessous en lien avec les figures 1 à 3 dans lesquelles les références des différents éléments sont communes aux différentes figures.

Des modes de réalisation de dispositifs selon l'invention sont détaillés dans les figures 1A à 1D.

Chacun de ces dispositifs, ou chacun de ceux réalisés par les procédés décrits plus loin, comporte un substrat 2, en un premier matériau, qui est de préférence en matériau semi-conducteur et peut avantageusement être en silicium, par exemple du silicium monocristallin. On peut choisir un autre type de matériau, par exemple SiO2, ou SiGe, ou Ge, ou du saphir, ou de l'AsGa, ou du verre, ou du quartz.

A la surface de ce substrat se trouve au moins un réseau de motifs 5 (ou premiers motifs) ou un regroupement ou un ensemble 7, de largeur w, de tels motifs 5. Les sommets des différents motifs sont sensiblement tous alignés dans un plan parallèle à celui du substrat 2. De même, les pieds des différents motifs sont tous sensiblement au même niveau par rapport à la surface du substrat qui les contient.

Un groupement 7 de motifs présente une symétrie au moins locale selon un plan P, P' perpendiculaire au plan du substrat 2 et de chacune des figures 1A - 7D.

Chaque motif est disposé de manière sensiblement perpendiculaire au substrat et a sensiblement la forme d'une paroi. Selon une dimension (celle perpendiculaire au plan de chacun des figures 1A-7D) il a une extension grande par rapport à sa largeur w ; cette dernière est mesurée dans le plan des figures 1A - 7D, et est sensiblement comprise entre 1 nm et 20 nm. De préférence chaque motif a un rapport de forme inférieur à 10; ce rapport de forme est défini comme le rapport entre la hauteur d'un motif, mesurée suivant une direction sensiblement perpendiculaire au plan du substrat, et sa largeur w. Les largeurs des différents motifs 5 sont avantageusement identiques entre elles. Dans le plan des figures 1A à 7D, chaque motif a une forme sensiblement rectangulaire. Dans un même réseau de motifs, ceux ci sont disposés parallèlement les uns aux autres. Il en résulte, dans le plan des figures 1A - 7D, une forme de peigne.

Une tranchée ou nano-tranchée 6 (ou motif d'un deuxième type de motifs) sépare deux motifs 5 (ou motif d'un premier type de motifs) voisins quelconques, d'une distance sensiblement comprise entre 1 nm et 100 nm. Les largeurs des différentes nanotranchées 6 sont avantageusement identiques entre elles. Le fond de chaque tranchée 6 est en un matériau différent de celui des motifs 5. Il est possible de graver sélectivement l'un de ces deux matériaux par rapport à l'autre.

Chacune des figures 1A - 7D révèle que l'alternance motif/nano-tranchée est composée par une alternance de couches minces 4(i).

Dans un dispositif suivant l'invention, le couple formé par les deux types de matériaux de l'alternance motif/nano-tranchée est avantageusement Si/SiGe_{y}, avec y>20%. Alternativement, ce couple de matériau peut être choisi parmi les couples de matériaux suivants : Si/SiO2, HfO2/SiO2, SiO2/Si3N4, ZrO2/SiO2, Si/Au, Si/Pt, Si/Rh, Si/NO, SiO2/Au; il peut s'agir d'un couple semi-conducteur/métal ou métal/métal tel que Au/Cu ou d'un couple de métaux nobles.

Un premier dispositif selon l'invention est représenté en figure 1A.

Dans ce cas chaque motif 5 a une hauteur Z par rapport à la surface libre voisine 2' du substrat 2. Le sommet de chaque motif dépasse, par rapport à cette surface, de cette hauteur Z.

Les nanotranchées ont dans cet exemple une profondeur Z', mesurée par rapport au sommet des motifs, ici sensiblement égale à Z. Avantageusement, le matériau du fond des nanotranchés est composé du même matériau que le substrat 2.

Les motifs 5 sont, eux, composés en un matériau différent de celui du substrat, avantageusement en SiGe_{yGe} (yGe>17%) pour un substrat 2 en Si.

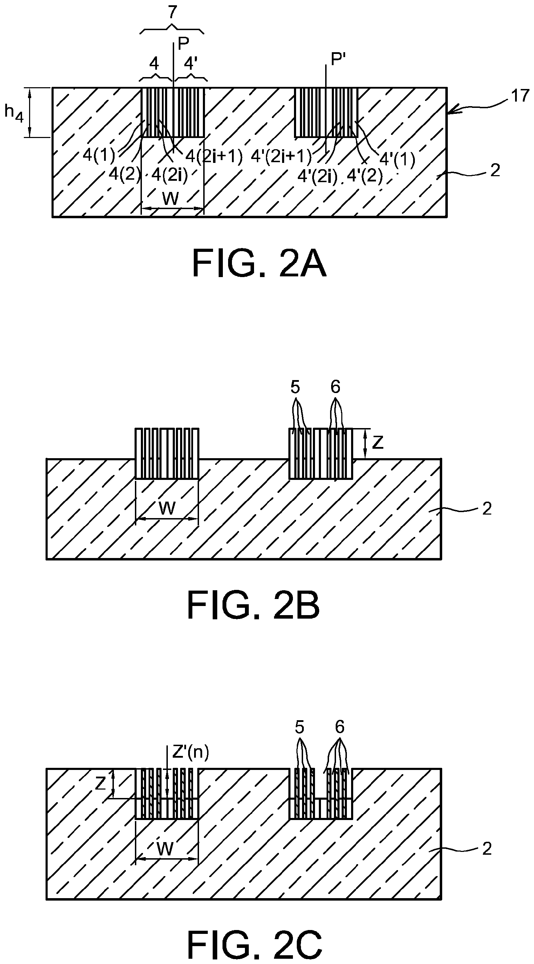

Dans le mode de réalisation illustré un groupement 7 de motifs présente une symétrie selon un plan P perpendiculaire au plan du substrat 2. Ceci vaut aussi pour chacune des figures 1A - 1E et pour chacun des dispositifs obtenus avec les procédés des figures 2A - 7D. D'un côté de ce plan, on trouve une alternance de deux matériaux sous la forme des couches 4(1), 4(i),....4(n) (n peut être compris entre 2 et 10⁴, ou par exemple entre 2 et 100). De l'autre côté de ce même plan, on trouve une alternance, symétrique par rapport au plan de symétrie mentionné ci-dessus, de ces deux matériaux, sous la forme des couches 4'(1), 4'(2),....4' (n). La couche 4' (i) est symétrique de la couche 4(i) par rapport au plan P: ces deux couches ont même composition, même largeur et même hauteur. Ce type de symétrie peut se retrouver plus généralement dans les autres modes de réalisation. Mais il peut y avoir des modes de réalisation de l'invention pour lesquels cette symétrie n'est pas présente, par exemple si l'on masque une partie des la couche au moment d'une étape de gravure.

Un autre dispositif selon l'invention est représenté en figure 1B.

A la différence de la figure 1A, les sommets des motifs 5 sont sensiblement au même niveau que la surface 2' libre du substrat.

Le fond des nanotranchées 6 est à une profondeur Z' par rapport à cette même surface. Le matériau du fond des nanotranchés est alors différent du matériau du substrat 2.

Avantageusement, le matériau des motifs 5 est composé du même matériau que le substrat 2.

Comme pour le mode de réalisation précédent on trouve également dans chaque tranchée une symétrie, par rapport aux plans P, P', de composition et d'épaisseurs pour les couches 4(i) et 4'(i) de part et d'autre d'un plan de symétrie P perpendiculaire au substrat.

Un autre mode de réalisation de l'invention est présenté en figure 1C. Dans ce dispositif, comme pour le dispositif de la figure 1A, le sommet des motifs est à une hauteur Z au dessus de la surface libre 2' du substrat.

Cependant, à la différence des modes de réalisation précédents, il y a au moins deux nanotranchées qui ont des profondeurs différentes entre elles.

Comme pour le mode de réalisation précédent on trouve une symétrie de composition et d'épaisseurs pour les couches 4(i) et 4'(i) de part et d'autre d'un plan de symétrie P, P' perpendiculaire au substrat et au plan de la figure. De préférence, dans chaque tranchée, on trouve également une symétrie, de part et d'autre du même plan, pour les profondeurs des tranchées, on notera z'(2i) la profondeur des nanotranchées obtenues par gravure des couches 4(2i), 4'(2i).

Avantageusement les profondeurs z'(2i) sont croissantes en partant du bord du regroupement de motifs 7 et en allant vers le centre de ce regroupement de motifs 7. La même répartition se retrouve, de manière symétrique, de l'autre côté du plan P, P'.

De plus, au moins deux matériaux composant les fonds d'au moins deux nanotranchées ont des compositions différentes, la différence de composition influençant la vitesse de gravure.

Deux couches composant le fond des nanotranchées 6 ayant une même profondeur ont une composition identique.

Deux couches composant le fond des nanotranchées 6 ayant des compositions différentes ont des profondeurs différentes.

Comme expliqué plus loin, la répartition inégale des profondeurs de tranchées permet de compenser, lors d'une nano-impression, des inhomogénéités de l'épaisseur résiduelle de matériau dans lequel l'impression est réalisée.

Un autre mode de réalisation de l'invention est présenté dans le dispositif de la figure 1D.

Dans ce dispositif, comme pour le dispositif de la figure 1B, le sommet des motifs 5 est au même niveau que la surface libre 2' du substrat 2.

De la même façon que dans le dispositif décrit dans la figure 1C, il y a une disparité de profondeur de tranchée entre au moins deux nano-tranchées 6.

On notera z'(2i+1) la profondeur des nanotranchées obtenues par gravure des couches 4(2i+1), 4'(2i+1), i=0,...n.

Avantageusement les profondeurs z'(2i+1) sont décroissantes en partant du bord du regroupement de motifs 7 et en allant vers le centre de ce regroupement de motifs 7. La même répartition se retrouve, de manière symétrique, de l'autre côté du plan P, P'.

On retrouve donc la symétrie en composition et en épaisseur de la figure 1C, mais aussi en profondeurs des tranchées.

Les observations relatives à la composition et faites dans le cadre du mode de réalisation de la figure 1C restent valables.

Un autre dispositif selon l'invention est représenté en figure 1E.

A la différence de la figure 1B, les sommets des motifs 5 sont sous le niveau de la surface 2' libre du substrat, à une profondeur Z₁' par rapport à cette surface.

Le fond des nanotranchées 6 est à une profondeur Z₂' par rapport à cette même surface. Le matériau du fond des nanotranchés est alors différent du matériau du substrat 2. Le matériau des motifs 5 peut être composé du même matériau que le substrat 2 ; mais, dans ce cas, on masque le substrat 2 pour attaquer la zone 7 sans attaquer la surface du substrat 2. Ou bien on peut réaliser un autre matériau sur le substrat 2 (comme dans le cas d'un SOI) dans lequel on fait des tranchées et sur les flancs duquel on fait la croissance des couches. Ce matériau est différent du matériau des motifs 5 et 6 et est gravé sélectivement par rapport à ces éléments 5 et 6.

Comme pour le mode de réalisation précédent on trouve également dans chaque tranchée une symétrie, par rapport aux plans P, P', de composition et d'épaisseurs pour les couches 4(i) et 4'(i) de part et d'autre d'un plan de symétrie P perpendiculaire au substrat.

D'autres structures d'un dispositif selon l'invention seront décrites dans le cadre des exemples de procédés ci-dessous.

Un procédé selon l'invention est illustré dans les figures 2A à 2E.

On part d'un substrat 2 comportant au moins un multicouche 17. Celui-ci comporte deux zones composites 4 et 4' symétriques l'une de l'autre par rapport à un plan P perpendiculaire au substrat et au plan de la figure, et contenant, respectivement, des couches 4(i), 4'(i). Les couches 4(i) (respectivement 4'(i)) sont composées de façon alternée de deux matériaux pouvant être gravés de façon sélective l'un par rapport à l'autre. Les deux zones composites forment un groupement 7 de largeur w et une profondeur h4. Les couches 4(i), 4'(i) ont au moins une portion perpendiculaire au plan principal du substrat 2 ; cette portion affleure la surface du substrat. Préférentiellement, un des matériaux alternés est gravé à la même vitesse que le substrat, avantageusement c'est le même matériau que le substrat. Si le substrat est en silicium, les deux matériaux sont avantageusement à base de Si et à base de SiGe.

Dans les figures 2B et 2C, il est procédé à une gravure sélective d'un matériau par rapport à l'autre.

La gravure peut graver préférentiellement le substrat et le matériau des couches alternées ayant une vitesse de gravure proche de celle du substrat formant ainsi des motifs 5 à la surface du dispositif (figure 2B).

Il est alors obtenu une structure du type de la figure 1A. On peut aussi obtenir une structure du type de la figure 1C à condition de choisir les compositions adéquates des couches 4(2i) et 4'(2i), comme déjà expliqué ci-dessus en liaison avec la figure 1C.

La structure ainsi obtenue peut par exemple être utilisée en tant que moule de nano-impression pour former des tranchées dans un matériau d'impression ou pour servir de négatif « master » pour former un moule de nano-impression.

Alternativement, il est possible de choisir la gravure de telle sorte que le matériau gravé préférentiellement soit gravé de façon sélective par rapport au substrat et au matériau qui a une vitesse de gravure proche ou égale à celle du substrat (figure 2C) .

Il est alors obtenu une structure du type de la figure 1B. On peut aussi obtenir une structure du type de la figure 1D à condition de choisir les compositions adéquates des couches 4(2i+1) et 4'(2i+1), comme déjà expliqué ci-dessus en liaison avec la figure 1D.

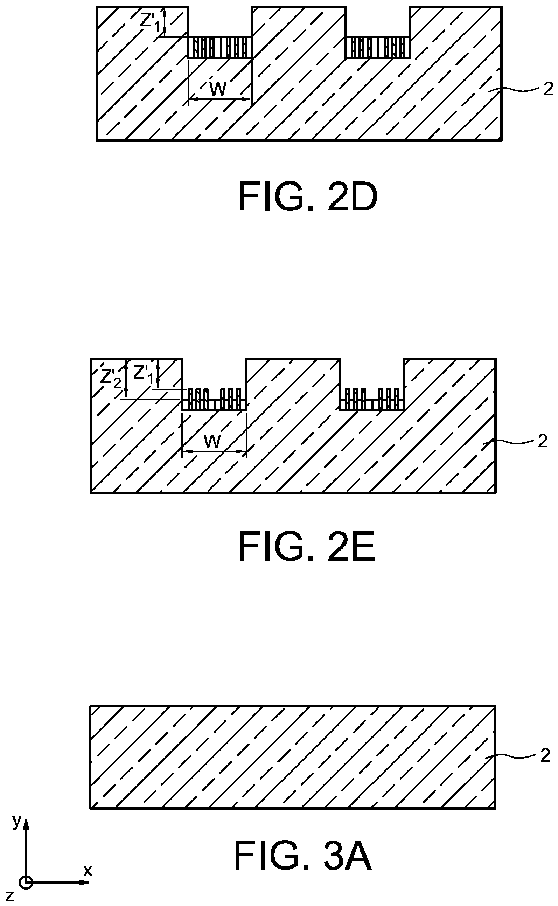

Dans le cas des figures 2D et 2E, il est d'abord procédé (figure 2D) à une gravure anisotrope des deux matériaux, ce qui conduit à une réduction du niveau des deux matériaux dans chaque tranchée, à un niveau sensiblement identique pour ces deux matériaux.

Puis (figure 2E) il est procédé à une gravure sélective d'un matériau par rapport à l'autre. Il est alors obtenu une structure du type de la figure 1E.

La structure alors obtenue peut par exemple être utilisée en tant que moule de nano-impression pour former des motifs saillants de matériau d'impression ou pour servir de négatif « master » pour former un moule de nano-impression.

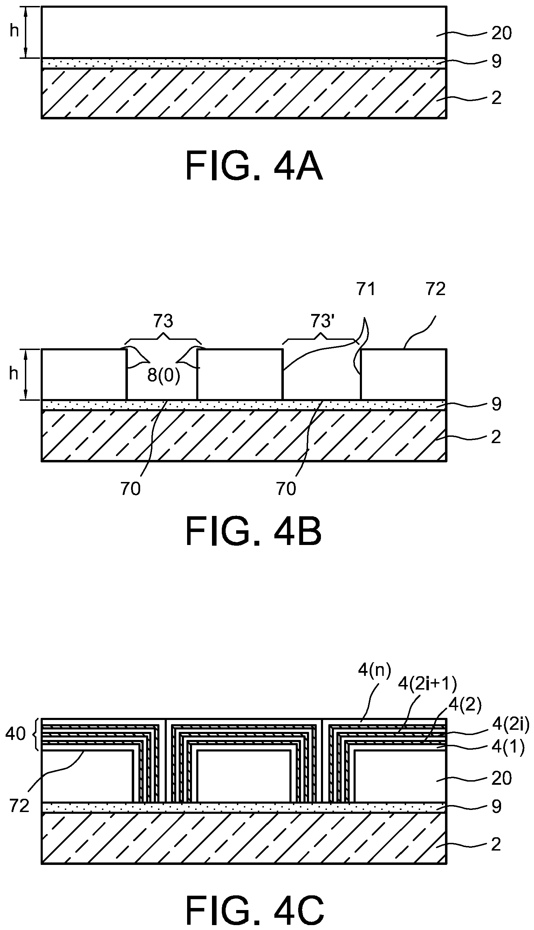

Les figures 3A à 5F illustrent des modes de réalisation de l'invention les modes de réalisation des figures 4A - 5F étant couverts par les revendications) permettant d'obtenir, en particulier, une structure initiale du type de celle décrite en figure 2A. Certains de ces procédés permettent d'obtenir d'autres structures. Ces procédés comportent aussi une étape de gravure subséquente.

Un tel procédé (nom couvert par les revendications, mais dont des aspects peuvent être utilisés en combinaison avec des modes de réalisation selon l'invention) est représenté dans les figures 3A à 3G.

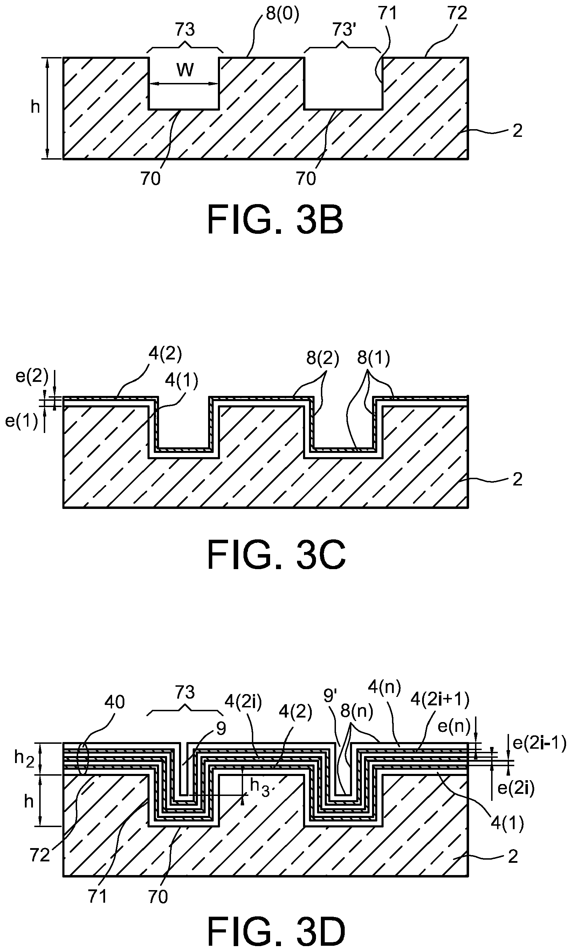

Dans un substrat **2,** avantageusement en matériau semi-conducteur, par exemple en silicium (figure 3A), sont gravées des tranchées 73 et 73' de profondeur h et de largeur w (figure 3B). On distingue donc trois types de surfaces sur ou dans le substrat : les fonds 70 de tranchés, les flancs 71 des tranchés et le sommet 72 du substrat (la partie supérieure du substrat 2, qui est non affectée par la gravure des tranchées). Ces surfaces, qui sont formées en un matériau compatible avec le dépôt des couches conformes alternées choisies, définissent une topologie de surface 8(0), c'est-à-dire une surface 3D comprenant le sommet du substrat et les surfaces des tranchées qui sont situées à des niveaux différents suivant l'axe y.

Une épaisseur e(1) d'une première couche conforme 4(1), de faible rugosité, et en un premier matériau, est déposée sur l'ensemble de la surface 8(0) (figure 3C). D'une manière générale, dans toute la présente demande, on appelle couche conforme une couche épousant la topologie de la surface 8(0) sur laquelle elle est déposée. Ce premier matériau est choisi de façon à pouvoir être gravé de façon sélective par rapport au substrat 2. Il est par exemple en SiGe. Cette couche a une surface libre 8(1).

Ensuite, sur cette surface 8(1) en un premier matériau est déposée une couche 4(2), conforme et de faible rugosité, d'épaisseur e(2) en un deuxième matériau (figure 3C). Le matériau de la couche 4(2) est choisi de manière à pouvoir être gravé de façon sélective par rapport au matériau de la couche 4(1). D'une manière générale, dans toute la présente demande, une gravure est dite sélective entre deux matériaux si lors de l'étape de gravure un des matériaux est gravé préférentiellement par rapport à l'autre, c'est-à-dire que la vitesse de gravure de l'un des matériaux est supérieure à la vitesse de gravure de l'autre matériau. Préférentiellement le matériau de la couche 4(2) est gravé à la même vitesse que le substrat 2, avantageusement ce matériau est le même que celui du substrat, par exemple du Silicium.

Ces étapes sont répétées de façon à obtenir n couches conformes 4(1) à 4(n) d'épaisseurs e1 à e(n) formant un film composite 40 d'épaisseur h2 sur l'ensemble de la topologie (figure 3D). La couche 4(i+1) est déposée sur la surface 8(i) de la couche i ; la couche 4(i+1) étant en matériau choisi de façon à pouvoir être gravé de façon sélective par rapport au matériau composant la couche sous-jacente 4(i).

Est ainsi formée une alternance entre les deux matériaux cités précédemment, qui peuvent être gravés sélectivement l'un par rapport à l'autre :
- les couches impaires 4(1) à 4(2x+1) étant composées du premier matériau,
- et les couches paires, qui sont disposées de manière alternée avec les couches impaires, formées à base du deuxième matériau. Ces couches paires sont référencées 4(2) à 4(2x), ou 4(2) à 4(2x+2), selon qu'il y a un nombre total impair ou pair de couches déposées sur le substrat.

Chacune des épaisseurs e(1) à e(n) est comprise entre quelques nanomètres et quelques dizaines de nanomètres, par exemple, entre 1 nm et 100 nm, préférentiellement entre 1 nm et 20 nm.

De préférence les couches alternées paires ont toutes une même épaisseur ; de même, les couches alternées impaires ont de préférence toutes une même épaisseur. Avantageusement, chaque couche a une épaisseur de, par exemple, environ 10 nm +/- 2 nm. Les couches alternées peuvent être toutes de même épaisseur, par exemple, les épaisseurs e(1) à e(n) peuvent être égales à 10 nm.

Ces couches peuvent être polycristallines de faible rugosité. Préférentiellement, au moins un des matériaux déposé est amorphe ou a une structure monocristalline ; avantageusement les deux matériaux déposés sont amorphes ou ont une structure monocristalline. Le dépôt de chaque couche peut être fait par exemple par CVD ou PECVD, ou encore par épitaxie.

L'épaisseur totale h2 du film 40 composé des couches alternées peut être telle que les tranchées les plus fines sont remplies par ce film 40.

L'épaisseur h2 est de préférence strictement inférieure à la profondeur h des tranchées. Elle est telle que, dans chaque tranchée 73, 73' une portion de la surface 8(n) de la couche la plus externe de l'empilement (couche 4(n)) soit, selon l'axe y, à un niveau inférieur à celui du sommet 72 du substrat 2. Il y a alors au moins une hauteur h3 de matériau de la couche 4(n) sous le niveau 72 du substrat ou compris entre le niveau 72 du substrat et le niveau du fond des tranchées.

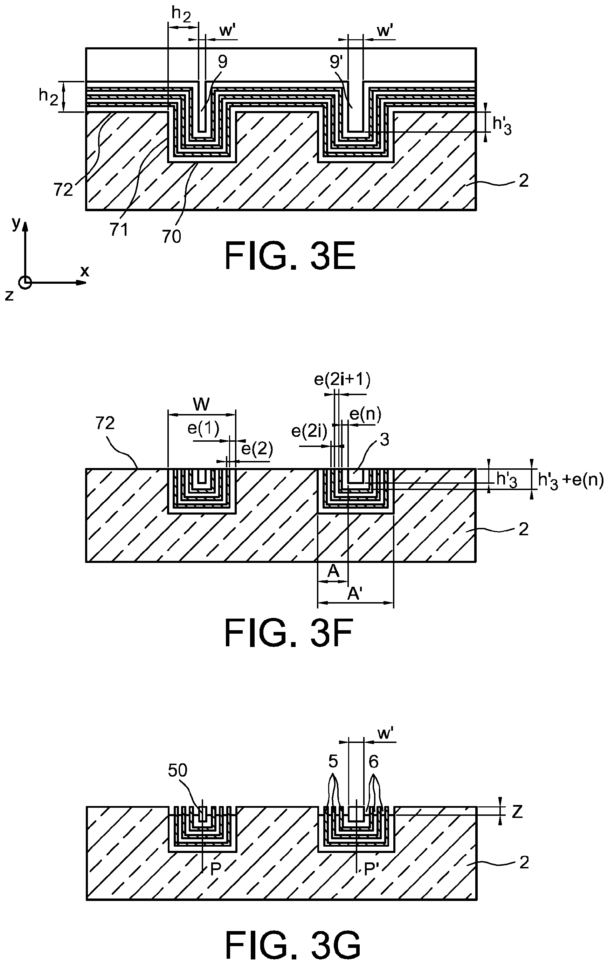

Dans le cas où une tranchée n'est pas entièrement remplie par les couches conformes alternées, il y a une tranchée résiduelle 9,9' de largeur w' présente au milieu de la tranchée non remplie, au dessus de l'empilement 40. On dépose alors un matériau de remplissage 3, choisi de façon à pouvoir être gravé de façon sélective par rapport au matériau composant la dernière couche conforme 4(n) de l'empilement 40 ; avantageusement cette dernière couche conforme est telle que le matériau de remplissage 3 puisse être gravé à une vitesse proche de celle du matériau du substrat (figure 3E). Par exemple le matériau de remplissage 3 est identique à celui du substrat.

Le matériau de remplissage 3 est déposé sur l'ensemble de la surface 8(n), remplissant ainsi les tranchées 9, 9', de largeur w', qui forment une topologie résiduelle de la surface 8(n). Ces tranchées 9, 9', remplies par le matériau de remplissage 3, sont séparés du fond 70 et des flancs 71 des tranchées 73, 73' ainsi que du sommet 72 du substrat par le film 40 composite d'épaisseur h2.

Puis le dispositif est aminci d'une épaisseur au moins égale à h2, par exemple par polissage mécano-chimique, de façon à éliminer au moins toute l'épaisseur du film composite 40 présente au dessus du sommet 72 du substrat (figure 3F) ainsi que l'éventuelle couche de matériau de remplissage 3 présente au dessus du sommet 72 du substrat.

L'amincissement a avantageusement lieu de façon à laisser une épaisseur minimale h3' de matériau de remplissage 3 dans les tranchées 73, 73' (figure 3F). Cette hauteur minimale permet de conserver, après polissage, une hauteur minimale h3'+e(n), suivant l'axe y, de matériau de la dernière couche déposée 4(n).

Il est ainsi obtenu une structure à partir de laquelle les étapes des figures 2B ou 2C vont pouvoir être réalisées.

Cette structure est donc ensuite soumise (figure 3G) à une gravure chimique ou physique ou assistée chimiquement (gravure type RIE); cette gravure a comme particularité de graver sélectivement l'un des deux matériaux qui composent les couches conformes alternées 4(i) par rapport à l'autre. Un des deux matériaux est gravé moins vite que l'autre, formant ainsi des motifs 5 à la surface du dispositif.

Dans l'exemple de la figure 3G, les variation de profondeur de gravure forment des motifs 5 de largeur e(2i) séparés entre eux par des nano-tranchées 6, de largeur e(2i+1) et de profondeur Z. Ces motifs sont situés dans les tranchées 73, 73' remplies par les couches conformes alternées 4(i). Dans une même tranchée 73 pour laquelle un matériau de remplissage 3 a été utilisé, le groupe de motifs est séparé en deux parties par un motif 50 de largeur w', en matériau de remplissage. Les motifs 5, dans ce mode de réalisation de l'invention, sont composés par le deuxième matériau, par exemple un matériau identique à celui du substrat ; le fond des nano-tranchées 6 est composé du premier matériau.

On a ainsi obtenu une structure qui présente une symétrie par rapport à un plan P, P' qui passe par une portion en matériau de remplissage, le motif 50. Ce plan sépare donc le groupe de motifs réalisé dans une même tranchée 73 en deux parties symétriques.

On voit sur la figure 3G qu'une particularité de ce mode de réalisation est qu'une couche 4(i) de l'empilement 40 est disposée dans une tranchée 73 de manière continue de chaque côté de la tranchée et dans la partie inférieure de celle-ci. Les conditions de symétrie, par rapport au plan P, d'épaisseur, de composition, de vitesse de gravure sont donc assurées.

Alternativement, il est envisageable que la gravure sélective soit choisie de façon à produire des motifs, saillants par rapport au substrat, composés du premier matériau comme il sera décrit dans le mode de réalisation suivant de l'invention.

Le dispositif de la figure 1G peut être utilisé comme moule ou tampon d'impression pour former un moule de nano-impression ou directement comme moule de nano-impression.

Un autre mode de réalisation d'un procédé selon l'invention est décrit dans les figures 4A à 4E.

Dans ce mode de réalisation, le dispositif est réalisé dans un substrat de type SOI, c'est-à-dire, un substrat comportant une couche isolante enterrée 9 séparant une couche superficielle 20 fine de hauteur h, en matériau semi-conducteur, d'un substrat épais 2 assurant la rigidité de l'ensemble (figure 4A). La couche isolante enterrée 9 est choisie de façon à limiter et/ou empêcher le dépôt des matériaux composant les couches conformes alternées.

Cette couche isolante peut avantageusement être en oxyde de silicium et le film superficiel en silicium.

Comme dans le premier mode de réalisation de l'invention, des tranchées 73, 73' sont gravées dans la couche superficielle 20, par exemple par photolithographie. La couche isolante enterrée 9 forme couche d'arrêt pour cette gravure. Le fond des tranchées est donc constitué par la couche 9 en matériau isolant (figure 4B). La profondeur des tranchées est donc égale à l'épaisseur h du film superficiel 20.

Le matériau formant la couche d'isolante enterrée 9 et formant donc le fond des tranchées ne permettant pas le dépôt des matériaux prévus pour les couches conformes alternées 4 (i), la surface active de dépôt 8(0) est composée par le sommet 72 du substrat ainsi que par les flancs 71 des tranchées 73. Cette surface active donc est composée presque uniquement de surfaces de la couche superficielle 20.

Comme dans le mode de réalisation décrit précédemment en liaison avec les figures 3C à 3E, il est procédé au dépôt d'une couche composite 40, d'épaisseur h2, composée de couches conformes 4(i) telles qu'il y ait formation d'une alternance entre un premier matériau et un deuxième matériau (figure 4C). Les couches 4(i+1) sont déposées de façon conforme sur la surface 8(i) de la couche 4 (i), la couche 4(i+1) étant composée en matériau dont la gravure est sélective par rapport au matériau composant la couche conforme 4(i).

Ainsi, chaque couche est déposée au moins sur les deux flancs 71 de chaque tranchée 73, et ce de manière symétrique.

Ces couches sont choisies suivant les mêmes critères que dans le premier mode de réalisation de l'invention. Cependant, le matériau isolant 9, composant le fond des tranchées, ne permet pas le dépôt des couches conformes alternées. Il n'y a donc pas de dépôt des couches 4(i) suivant le fond des tranchées; les portions de couches alternées présentes dans les tranchées 73, 73' sont uniquement orientées perpendiculairement au plan moyen du substrat 2.

La hauteur de chaque couche conforme alternée comprise entre le fond 70 des tranchées et le sommet 72 du substrat est, dans ce mode de réalisation, toujours égale à la profondeur h des tranchées. Il n'y a donc pas de limitation à l'épaisseur h2 de la couche composite 40, par rapport à la profondeur h des tranchées, contrairement au premier mode de réalisation.

Dans le cas où certaines tranchées ne sont pas remplies entièrement par la couche 40, il est ensuite avantageusement procédé au remplissage des parties non remplies de ces tranchées par un matériau de remplissage tel que décrit dans le mode de réalisation ci dessus.

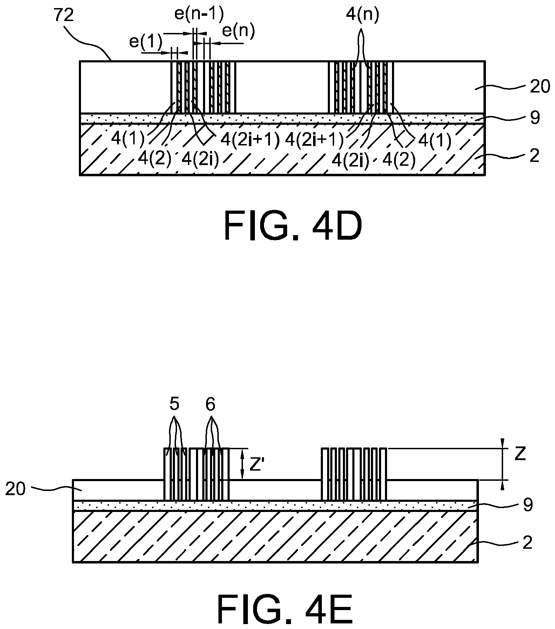

Ensuite, le dispositif est aminci, par exemple lors d'un polissage mécano-chimique, de façon à enlever au moins les portions de la couche composite 40 qui surmontent le sommet 72 du substrat et ainsi obtenir un dispositif dans lequel l'alternance des deux matériaux, pouvant être gravés de façon sélective l'un par rapport à l'autre, n'est présente que dans les zones correspondant aux tranchés 73, 73' (figure 4D). A la différence du mode de réalisation précédent, il n'y a pas, dans les tranchées 73, 73', de portions de couches alternées 4(i) parallèles au plan du substrat (comparer avec figures 3F et 3G). Le contrôle de l'épaisseur d'amincissement est donc moins critique que dans le premier mode de réalisation de l'invention.

Il est ainsi obtenu une structure à partir de laquelle les étapes des figures 2B ou 2C vont pouvoir être réalisées.

Cette structure est donc ensuite soumise à une gravure chimique ou physique (figure 4E); cette gravure a comme particularité de graver sélectivement l'un des deux matériaux qui composent les couches conformes alternées 4(i) par rapport à l'autre. Un des deux matériaux est gravé moins vite que l'autre, formant ainsi des motifs 5 à la surface du dispositif.

Dans l'exemple de la figure 4E, les variations de profondeur de gravure forment des motifs 5 de largeur e(2i+1) séparés entre eux par des nano-tranchées 6, de largeur e(2i) et de profondeur Z. Le substrat 2 est également gravé à une vitesse de gravure proche de celle du matériau des couches 4(2i). Ces motifs sont donc saillants par rapport à la surface du reste du substrat 2. Dans une même tranchée 73 pour laquelle un matériau de remplissage 3 a été utilisé, le groupe de motifs est séparé en deux parties par un motif en matériau de remplissage. Les motifs 5, dans ce mode de réalisation de l'invention, sont composés du premier matériau; le fond des nano-tranchées 6 est composé du deuxième matériau, par exemple un matériau identique à celui du substrat.

On a ainsi obtenu une structure qui présente une symétrie par rapport à un plan P, P' qui passe éventuellement par une portion en matériau de remplissage. Ce plan sépare donc le groupe de motifs réalisé dans une même tranchée 73 en deux parties symétriques.

Alternativement, il est envisageable que la gravure sélective soit choisie de façon à produire des motifs, non saillants par rapport au substrat, composés du deuxième matériau comme il a été décrit dans le mode de réalisation précédent.

Le dispositif de la figure 4E peut être utilisé comme moule ou tampon d'impression pour former un moule de nano-impression ou directement comme moule de nano-impression.

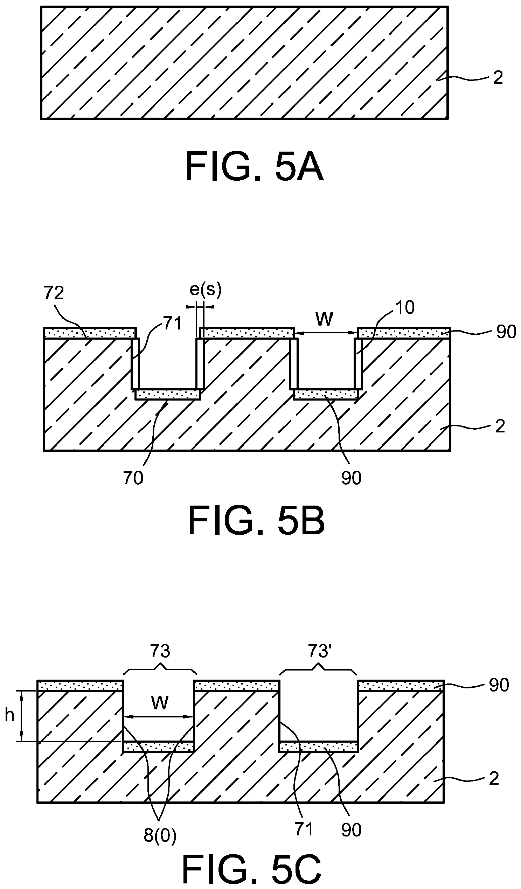

Un autre mode de réalisation de l'invention est décrit dans les figures 5A à 5F.

La description de ce mode de réalisation de l'invention ne s'attardera que sur les variantes par rapport aux modes de réalisation précédents.

Dans un procédé selon le troisième mode de réalisation de l'invention, des tranchées 73, 73' de largeur w, sont gravées dans un substrat 2, avantageusement en matériau semi-conducteur, par exemple en silicium (figure 5A).

Puis une épaisseur eₛ de matériau de type espaceur 10 est déposée sur les flancs 71 des tranchées 73. Ce matériau est avantageusement choisi de façon à :
- pouvoir être retiré sélectivement par rapport au matériau du substrat 2 et par rapport à la future couche de matériau limitant le dépôt des couches conformes alternées,
- et à ne pas permettre la formation de ce dernier matériau.

Ce matériau est par exemple du Si ou du SiO2 ou du Si3N4 ou du HfO2 ou du SiGe...etc. Il est par exemple déposé par CVD sur l'ensemble des surfaces du substrat, puis gravé de façon anisotrope, de sorte qu'il ne reste de ce matériau que sur les flancs 71 des cavités 73.

Ensuite, sur l'ensemble des surfaces non recouvertes par l'espaceur 10 est formé, par dépôt ou par croissance, un matériau 90 limitant ou inhibant le dépôt des couches conformes alternées (figure 5B). La présence du matériau espaceur sur les flancs fait que ce matériau limitant les couches alternées, de type oxyde, par exemple en oxyde de silicium, n'est déposé dans ce mode de réalisation que suivant deux configurations, en fond 70 de tranchées et sur le sommet 72 du substrat.

Avantageusement, le matériau espaceur peut ensuite être retiré (figure 5C), par exemple par gravure sélective ou par dissolution. IL peut aussi être maintenu, par exemple dans le cas où il peut servir de couche d'accroche.

Comme pour les modes de réalisation précédents, des couches conformes alternées sont déposées sur la surface 8(0), cette surface correspondant aux surfaces non recouvertes par le matériau 90 limitant ou inhibant la croissance des couches conformes. Ladite surface 8(0) correspond donc soit à la surface du matériau espaceur, soit à la surface libérée lors du retrait du matériau espaceur. Cette surface 8(0) est une surface discontinue composée de l'ensemble des flancs 71 des tranchées 73, avec ou sans espaceur.

Les couches conformes alternées sont déposées par la même technique que dans les modes de réalisation précédents.

Sur la surface 8(0) est déposée une épaisseur e(1) de couche conforme 4(1) en un premier matériau, avec une surface libre 8(1). Sur cette surface 8(1) est déposée une épaisseur e(2) de couche conforme 4(2) composée du deuxième matériau et ayant une surface libre 4(2). Ce procédé est poursuivi, jusqu'à avoir n couches alternées, en alternant les deux matériaux. L'épaisseur e(i) de chaque couche est ajustée aux besoins de la configuration finale souhaitée et est avantageusement inférieure à 10 nm.

Du fait de la présence des couches de matériau 90 limitant la croissance des couches conformes sur le fond 70 des tranchées et le sommet 72 du substrat 2, les couches conformes alternées ne sont déposée que dans les tranchées, parallèlement aux flancs 71 des tranchées, c'est-à-dire perpendiculairement au plan du substrat 2.

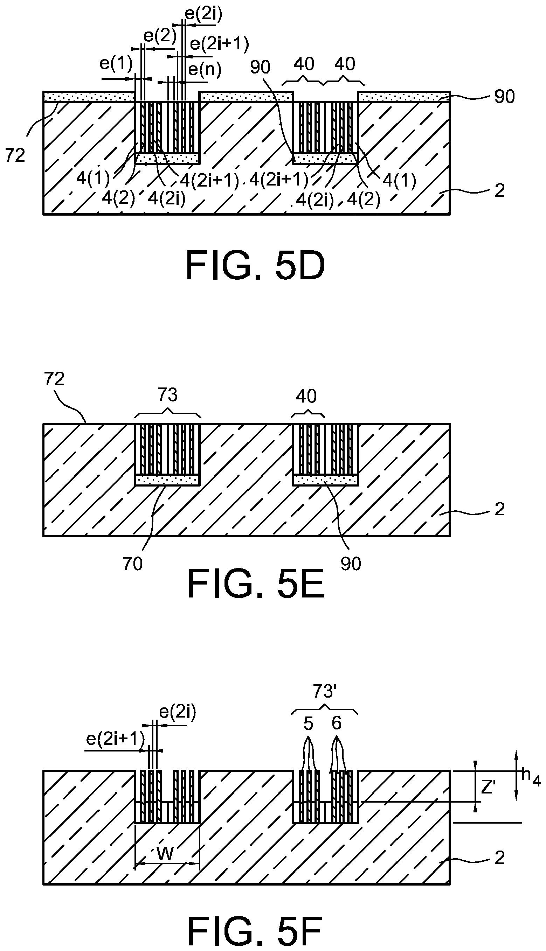

Puis, la surépaisseur présente au dessus du sommet 72 du substrat est éliminée (figure 5E). Cette surépaisseur est composée au moins de la couche 90 en matériau limitant ou inhibant le dépôt des couches conformes alternées 4(i). Cette couche 90 peut être retirée par polissage.

La couche 90 peut avantageusement être enlevée par retrait sélectif du matériau qui la compose, par exemple par attaque chimique. Les couches conformes alternées 4 (i), présentes dans les tranchées 73, 73' ne sont pas alors dégradées par un polissage mécano-chimique. Mais un polissage permet de mettre à jour cette alternance, une couches conformes étant déposée horizontalement sur la tranche d'épaisseur e(i) de la couche précédente.

Dans le cas où les tranchées 73 ne sont pas entièrement remplies par la couche composite 40, il est préférable de déposer un matériau de remplissage pour remplir les portions libres restantes. Il est alors préférable de procéder à un amincissement de ce matériau de remplissage, par exemple par polissage, pour en éliminer la surépaisseur.

Il est ainsi obtenu une structure à partir de laquelle les étapes des figures 2B ou 2C vont pouvoir être réalisées.

Cette structure est donc ensuite soumise à une gravure chimique ou physique (figure 5F); cette gravure a comme particularité de graver sélectivement l'un des deux matériaux qui composent les couches conformes alternées 4(i) par rapport à l'autre. Un des deux matériaux est gravé moins vite que l'autre, formant ainsi des motifs 5 à la surface du dispositif.

Dans l'exemple de la figure 5F, les variation de profondeur de gravure forment des motifs 5 de largeur e(2i) séparés entre eux par des nano-tranchées 6, de largeur e(2i+1) et de profondeur Z'. Ces motifs sont situés dans les tranchées 73, 73' remplies par les couches conformes alternées 4(i). Dans une même tranchée 73 pour laquelle un matériau de remplissage a été utilisé, le groupe de motifs est séparé en deux parties par un motif en matériau de remplissage. Les motifs 5, dans ce mode de réalisation de l'invention, sont composées par le deuxième matériau, par exemple un matériau identique à celui du substrat ; le fond des nano-tranchées 6 est composé du premier matériau.

On a ainsi obtenu une structure qui présente une symétrie par rapport à un plan P, P' qui peut éventuellement passer par une portion en matériau de remplissage. Ce plan sépare donc le groupe de motifs réalisé dans une même tranchée 73 en deux parties symétriques.

Alternativement, il est envisageable que la gravure sélective soit choisie de façon à produire des motifs, saillants par rapport au substrat, composés du premier matériau comme déjà décrit dans le mode de réalisation précédent de l'invention.

Le dispositif de la figure 5F peut être utilisé comme moule ou tampon d'impression pour former un moule de nano-impression ou directement comme moule de nano-impression.

A partir des dispositifs des figures 3F, 4D et 5E on peut également réaliser une structure telle que celle des figures 1E et 1E', par gravure anisotrope des deux types de matériaux déposés dans les tranchées, pour les amener tous deux au même niveau sous la surface du substrat (comme en figure 2D), puis par gravure de l'un des deux matériaux, pour obtenir des motifs saillants par rapport à un fond de nanotranchées, mais le sommet des motifs étant dans la tranchée.

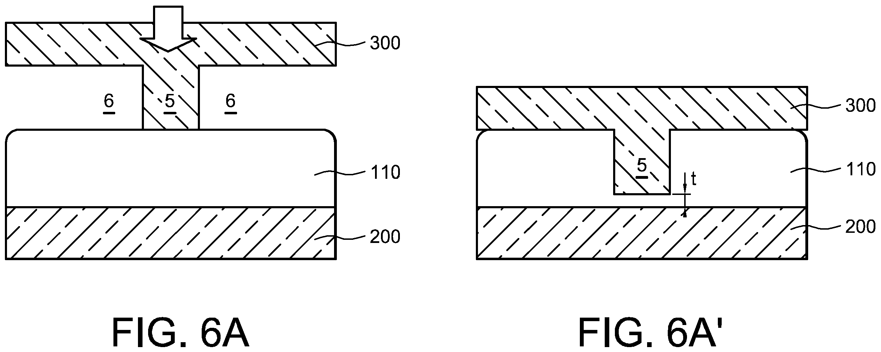

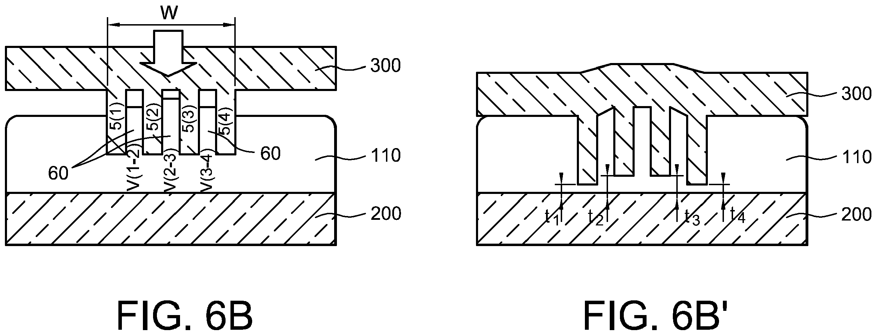

Lors de l'utilisation d'un moule 300 de nano-impression, le moule, comportant au moins un réseau 7 de motifs 5(j), est pressé sur une couche de matière malléable 110, présente sur un substrat 200, par exemple en résine; cette couche malléable 110 sera dénommée résine par la suite. Lors du pressage il reste une épaisseur tᵢ de résine 110 entre les motifs 5(j) et le substrat 200 à lithographier (voir les figures 6A, 6A' sur lesquelles un seul motif 5 est représenté). Dans le cas d'une variation de densité des motifs du moule ou dans le cas d'un réseau de motifs homogènes et denses (figure 6B), il peut y avoir, après pressage, une inhomogénéité locale de l'épaisseur résiduelle tᵢ de résine présente entre les différentes motifs 5(i) et le substrat 200 (figure 6B').

En effet, lors du pressage, la résine 110 reflue dans les volumes libres 6 situés autour des motifs, pour céder la place au motif 5 ou aux motifs 5(j). Dans un réseau régulier de motifs de largeur W, le volume libre v(j)-(j+1), séparant deux motifs voisins étant constant, le volume libre total situé à une distance D donnée d'un motif varie, en fonction de la position du motif dans le réseau, du fait des effets de bord. En effet, le volume libre total à une distance D d'un motif 5 diffère selon que le motif est au centre du réseau de motifs (figure 6B, motifs 5(2) et 5(3)) ou proche des bords du réseau (figure 6B, motifs 5(1) et 5(4)). Sur les figures 6A - 6D seuls quelques motifs sont représentés, mais l'effet expliqué ci-dessus se manifeste d'autant plus que le nombre de motifs est grand.

Dans le cas d'un dispositif réalisé selon l'invention, le réseau de motifs est composé des motifs 5 obtenus à l'intérieur d'une tranchée 73. Dans le cas d'un dispositif selon l'une des figures 1A, 4E ou 6B, le moule présentant des motifs 5 dépassant d'une hauteur Z par rapport au niveau du substrat 2 (ou 300 dans la figure 6B), il y a plus de volume libre près des bords du réseau 7 de motifs qu'au centre du réseau 7. Par contre, dans le cas d'un dispositif selon la figure 1B, le niveau des motifs 5 étant le même que celui du substrat 2, le volume libre disponible près du bord du réseau 7 de motifs est plus faible qu'au centre du réseau.

Moins il y a de volume libre disponible autour d'un motif 6 pressé dans la résine, moins la résine 110 peut refluer pour céder la place au motif et plus il reste d'épaisseur résiduelle. Dans un réseau de motifs, la différence entre le volume libre disponible autour d'un motif situé approximativement au centre du réseau et le volume libre disponible autour d'un motif situé approximativement à un bord du réseau conduit donc à une inhomogénéité de l'épaisseur résiduelle tᵢ.

Une étape de pressage, telle que l'une de celles des figures 6A, 6A', 6B, 6B', peut être suivie d'une étape de gravure, qui permet de mettre à nu le substrat 200 dans les zones dans lesquelles les motifs du moule ont pénétré. Lors de cette gravure, les points où l'épaisseur résiduelle est la plus fine sont gravés plus vite et la surface du substrat 200 sous jacent est atteinte en premier. La gravure est cependant poursuivie jusqu'à ce que cette surface du substrat 200 soit atteinte dans tous les motifs. Il y a donc surgravure ou gravure supplémentaire des motifs ouverts en premier. Pendant la durée de cette gravure supplémentaire, les motifs ouverts en premier sont élargis, du fait d'une gravure latérale inhérente aux procédés de gravure, par exemple une gravure plasma. Une inhomogénéité des épaisseurs résiduelles tⱼ entraîne donc une perte du contrôle des dimensions latérales après gravure. Ceci est problématique pour la réalisation de nanostructures qui nécessitent un contrôle dimensionnel le plus parfait possible.

Une manière de pallier ce problème est d'optimiser le volume libre disponible autour des motifs. Dans le cadre d'un procédé ou d'un dispositif selon l'invention on fait donc varier le volume libre v(j)-(j+1) entre deux motifs 5(j) au moyen d'une modulation de la profondeur z(j) des nano-tranchées 6. C'est le cas des structures des figures 1C et 1D.

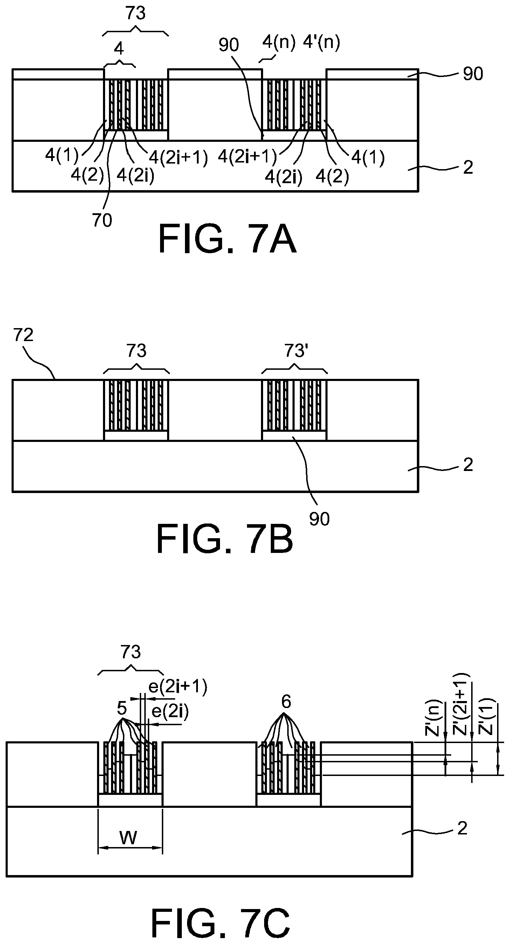

Un procédé permettant de réaliser ce type de structure est illustré dans les figures 7A à 7C ; ce procédé est illustré dans un mode de réalisation de l'invention du type de celui illustré par les figures 5A à 5F ; les figures 7A à 7C remplaçant alors les figures 5D à 5F. Il est alternativement possible d'utiliser le principe décrit ci-dessous par les figures 7A à 7C dans des modes de réalisation de l'invention conformes aux procédés décrits dans les figures 3A - 3G et/ou 4A - 4E.

Lors du remplissage des tranchées 73,73' par les couches conformes alternées, il est procédé à une modification de la vitesse de gravure d'un des matériaux. Cette modification est faite en modulant la composition d'un des matériaux alternés, d'une couche composée de ce matériau à une autre (figure 7A). A cette fin on peut prendre un matériau dont la composition chimique peut être ajustée d'une couche à l'autre, par exemple un alliage au moins binaire, dont on fait évoluer la composition d'une couche à l'autre. Des exemples de tels matériaux sont donnés plus loin.

Ainsi, dans un procédé avantageux selon ce mode de réalisation, au moins deux couches impaires (2i+1), composées du premier matériau, ont une composition différente. Par exemple, si le premier matériau est du SiGeₓ(x > 15% ou même x>20%), une couche impaire peut avoir une composition SiGeₓ et une autre couche impaire une composition SiGe_{x'}, 0<x'<x, x' étant de préférence lui aussi supérieur à 15% ou à 20%. En outre x peut varier d'une couche impaire à l'autre si plus de deux couches impaires ont des compositions différentes, x étant de préférence supérieur à 15% ou à 20% et inférieur à x'. Ces différences de composition sont choisies de façon à induire une variation de la vitesse de gravure des couches conformes impaires. Les vitesses de gravures ainsi obtenues peuvent par exemple être comprises entre celle du substrat, et/ou du deuxième matériau et celle du premier matériau, ici le SiGeₓ. De façon alternative, les couches paires, composées du matériau dont la vitesse de gravure est proche ou égale à celle du substrat, comportent une variation de composition entre au moins deux couches.

Puis, conformément aux procédés suivant l'invention, une étape d'amincissement a lieu de façon à éliminer au moins toute la matière présente au dessus du sommet 72 du substrat (figure 7B).

Lors de l'étape de gravure, la variation de composition entre certaines des couches impaires (alternativement paires) permet d'avoir une cinétique de gravure différente entre ces couches. Il est ainsi possible d'obtenir une structure de nano-impression comportant des motifs 5 fins séparés par des nanotranchées 6 de profondeur z(2i+1) variable par rapport au niveau du substrat (figure 7C). Le dispositif final est alors formé d'un substrat 2 comprenant des tranchées 6 de largeurs e(2i+1), de profondeurs variables z(2i+1), séparées par des motifs 5 composées en deuxième matériau.

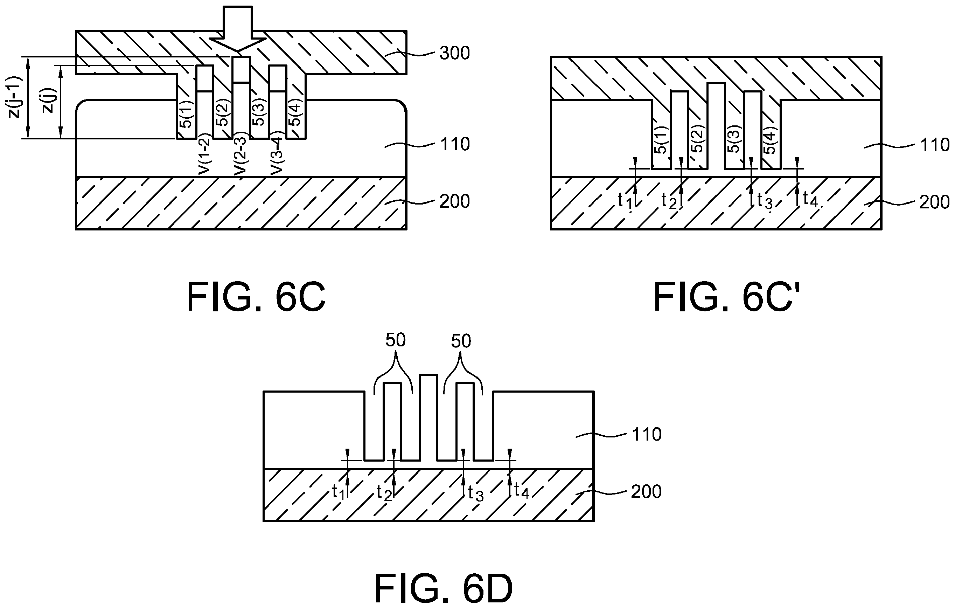

Une telle variation du niveau z(j) du fond des nanotranchées 6 séparant les motifs permet de modifier le volume libre v(j)-(j+1) de part et d'autre de chaque motif 5(j) (figure 6C). Ainsi on a des volumes libres, suffisants pour que le fluage de la résine 110 présente entre les motifs 5 et le substrat 200 soit homogène d'un motif 5(j) à l'autre. Il est ainsi possible d'influencer l'homogénéité des épaisseurs résiduelles tⱼ après pressage (figure 6C') telles qu'elles soient égales à t. Ainsi, après retrait du moule, l'inhomogénéité des épaisseurs tⱼ des fond des nanotranchées 50 formées par pression du moule 300 dans la résine 110 est minimisée (figure 6D).

Dans un procédé avantageux selon ce mode de réalisation, les variations de stoechiométrie entre différentes couches 4(i) composées d'un même type de matériau sont telles qu'après gravure le volume libre 6 entre deux motifs 5 soit optimisé de façon à minimiser l'inhomogénéité des épaisseurs résiduelles tᵢ lors de l'utilisation du moule de nano-impression.

Dans un cas où les motifs ont une différence de niveau Z avec le substrat (cas de la figure 1C), les compositions des couches 4(i) sont telles que les profondeurs z(2i) des nanotranchées sont plus importantes au centre des tranchées 73 (ou réseaux de motifs 7) qu'au bord de ces tranchées ou réseaux. De façon encore avantageuse, les compositions des couches 4(i) sont telles que les profondeurs z(2i) après gravure sont croissantes en partant du bord et en allant vers le centre des tranchées 73 ou vers le centre d'un réseau de motifs sur un des flancs (par exemple en figure 3F, on considère la zone de largeur A et pas la largeur totale A' de matériau remplissant toute une tranchée 73).

Alternativement (cas de la figure 1D), dans un cas où les motifs sont au niveau du substrat, les compositions des couches 4(i) sont telles que les profondeurs z(2i+1) des nanotranchées, après gravure, soient plus importantes au bord des tranchées 73 (ou réseaux de motifs 7) qu'au centre de ces tranchées ou réseaux. De façon encore avantageuse, les compositions des couches 4(i) sont telles les profondeurs z(2i+1) après gravure soient décroissantes en partant du bord et en allant vers le centre des tranchées 73 ou des réseaux 7.

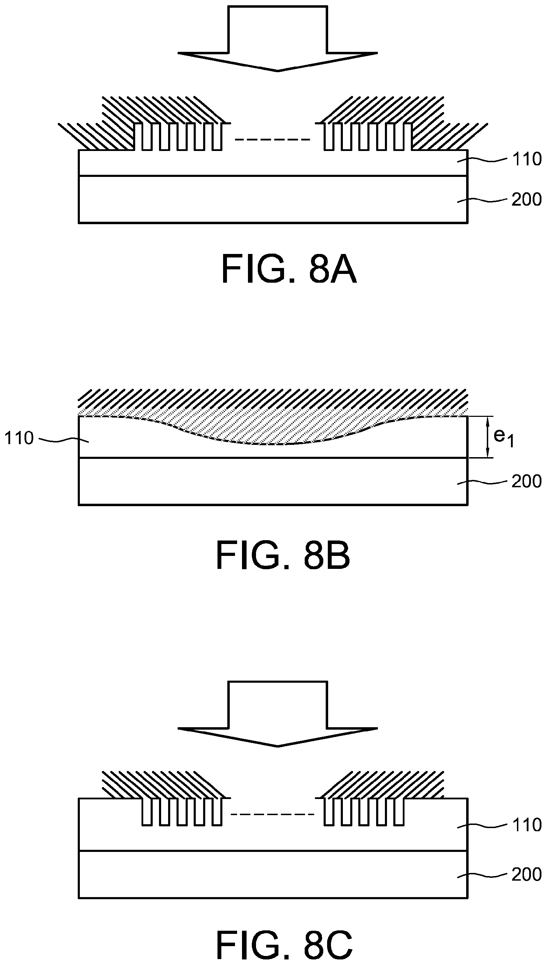

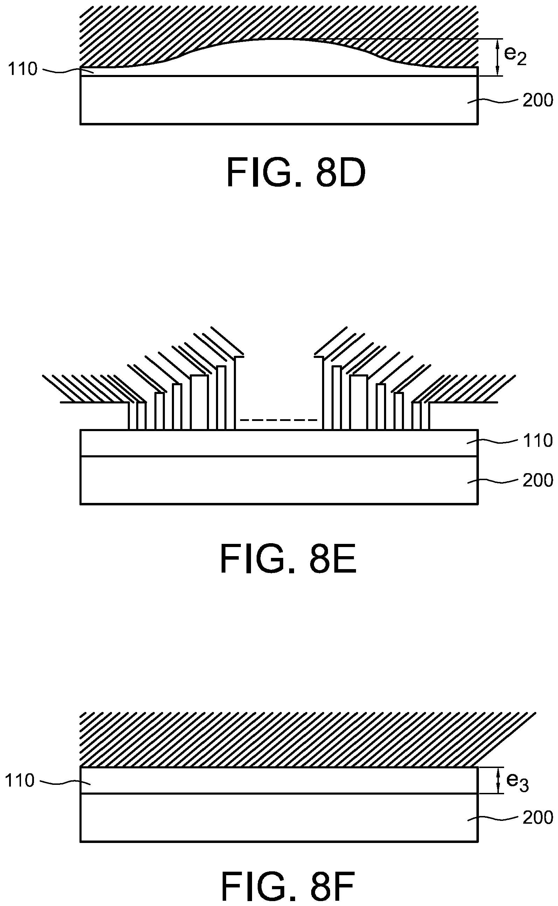

Pour optimiser les profondeurs locales des motifs, et en particulier la variation de profondeur entre les motifs situés au centre du réseau et ceux situés au bord, on peut procéder de la manière suivante, décrite en liaison avec les figures 8A - 8F. Les figures 8A, 8C, 8E représentent chacune un moule 300 au dessus d'une couche de résine 110, elle même disposée sur un substrat 200, les figures 8B, 8D, 8F représentent la forme générale de la résine après pressage du moule dans celle-ci (les motifs formés dans la résine ne sont pas représentés, seule est représentée sa forme générale). Le moule de la figure 8A est du type décrit ci-dessus en liaison avec la figure 1B, le moule de la figure 8C est du type décrit ci-dessus en liaison avec la figure 1A, et le moule de la figure 8E est du type décrit ci-dessus en liaison avec la figure 1C. C'est avec ce dernier moule que la résine 110 garde son épaisseur e₃ uniforme, même après pressage (figure 8F).

Dans un premier temps, on réalise un premier pressage dans la résine 110 avec un moule dont les profondeurs au niveau de toutes les dents sont identiques, c'est-à-dire un moule du type de la figure 1A ou de la figure 1C. On a alors un certain profil imprimé avec une distribution d'épaisseur résiduelle e₁, e₂ (figures 8B, 8D) que l'on peut mesurer, par exemple par une technique telle que MEB, ou scatterométrie, ou AFM.

Ces mesures permettent de déterminer la différence de hauteur qu'il faut réaliser entre différentes zones du moule pour homogénéiser l'impression et obtenir une épaisseur résiduelle plus homogène.

Par exemple dans le cas de la figure 8D l'épaisseur résiduelle e₂ est plus élevée au centre du réseau, il faut donc un moule plus profond à cet endroit, d'une profondeur supplémentaire égale à la différence mesurée entre le bord et le centre (si on considère que la référence se situe au bord du réseau).

En ajustant localement le volume disponible pour la résine on s'affranchit des écoulements de résine sur de longues distances, qui sont très longs à réaliser avec l'impression thermique.

Dans un procédé selon l'invention, les couches alternées 4(2i) (deuxième matériau) ont préférentiellement, lors de l'étape décrite dans les figures 3G, 4E et 5F, une cinétique de gravure de l'ordre de celle du substrat. Ce deuxième matériau, composant ces couches, peut avantageusement être le même que le matériau du substrat.

Le couple formé par les deux matériaux pouvant être gravés sélectivement et formant les couches conformes alternées 4(i) est avantageusement le couple Si/SiGe, SiGe contenant plus de 15% de Ge, avec l'oxyde de silicium pouvant limiter le dépôt des couches conformes 4(i) en Si et SiGe.

Un matériau dont la composition chimique peut être ajustée d'une couche à l'autre, par exemple un alliage au moins binaire tel que SiₓGe₁₋ₓ ou SiₓC₁₋ₓ ou SiₓN₁₋ₓ ou SiCₓN₁₋ₓ ou AlₓGa₁₋ₓAs. Le dépôt d'un tel matériau n'est pas nécessairement monocristallin : il peut être amorphe ce qui autorise donc une multitude d'alliage lors des étapes de dépôt.

On sélectionne un alliage pour la présente application en fonction de sa capacité à être gravé avec des vitesses différentes quand on fait varier la composition relative de chaque élément.

Pour ce faire on peut faire dans un premier temps des dépôts sur pleine plaque avec des compositions variables c'est-à-dire des x différents. Puis, avec une même chimie de gravure, on détermine les vitesses de gravure pour les différentes compositions. Si un rapport entre la vitesse de gravure d'un alliage de composition donnée et la vitesse de gravure du même alliage, mais de composition différente, est différent de 1 alors cet alliage, dans ces compostions, peut être utilisé.

Réciproquement, le substrat dans lequel sont formées les tranchées 73 peut avantageusement être choisi dans un des matériaux du couple choisi pour former les couches conformes alternées, par exemple Si, SiGe ou SiO2.

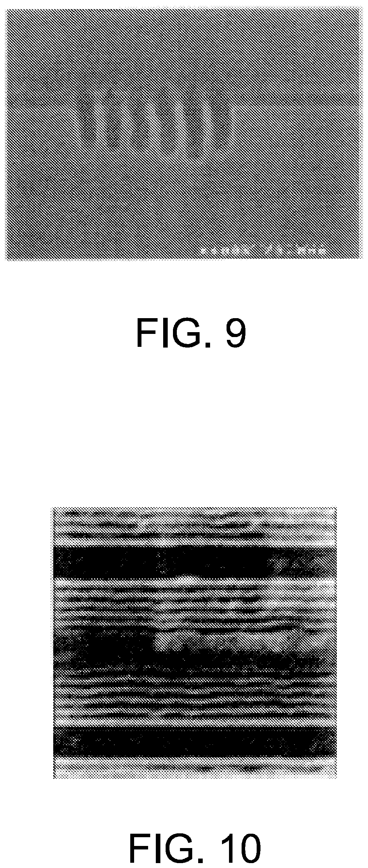

Des exemples de réalisation et d'utilisation de dispositifs selon l'invention sont donnés en figures 9 à 12.

Une coupe d'un dispositif selon la figure 1A, obtenu en appliquant l'un des procédés suivant l'invention, à base de Si et SiGe, le fond des nanotranchées étant en SiGe, est donnée en figure 9, obtenue par microscope électronique à balayage. Les motifs (en Si) séparés par des nanotranchées (en SiGe) y sont visibles, le niveau du sommet des motifs étant sensiblement égal à celui du substrat.

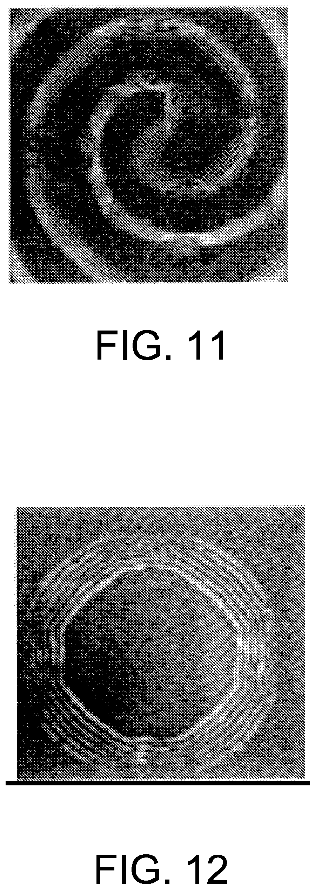

Les figures 10 et 11 sont des images obtenues par microscope électronique à balayage, en vue de dessus, le plan de ces deux figures étant le plan du substrat (2) de la figure 1A. Ces deux figures illustrent différents dispositifs (également en Si pour les premiers motifs et en SiGe pour les deuxièmes motifs) obtenus par des procédés suivant l'invention :
- en figure 10 (image de 8µm x 8 µm) : un dispositif sans matériau de remplissage au centre de la tranchée, dans une tranchée en spirale, formant ainsi un réseau de motifs dont le dessin global suit la forme initiale de la tranchée, séparés par des nanotranchées.
- en figure 11 (image de 750 nm x 750 nm) : un deuxième dispositif selon l'invention, dans lequel les tranchées sont sous forme d'un réseau de tranchées. Les tranchées n'étant pas entièrement remplies par les couches alternées, il y a dans chaque tranchée deux réseaux de motifs séparés par une épaisseur en matériau de remplissage. Les motifs obtenus ont une largeur de 10 nm et sont espacés par des nano-tranchées de largeur 10 nm.

La figure 12 (image de 1µm x 1µm) montre la topologie obtenue sur une couche malléable après pressage d'un moule de nano-impression dans une résine puis démoulage, le moule étant fabriqué suivant l'invention et la tranchée dans laquelle ont été réalisés les motifs suivant l'invention étant circulaires.

Ces motifs peuvent être obtenus par formation de facettes, chacune étant droite ; c'est le cas lorsqu'on utilise un matériau cristallin, peu approprié à former des courbes. Si on utilise un matériau amorphe, on peut réaliser toute forme, y compris courbée (ce qui est le cas de la figure 12 par exemple).

D'une manière générale, la sélectivité d'un matériau par rapport à l'autre concerne une gravure chimique ou physique ou assistée chimiquement. On peut par exemple obtenir des informations sur les comportements des matériaux par rapport à divers types de gravure dans :
- Handbook of Plasma Processing Technology: Fundamentals, Etching, Deposition, and Surface Interactions (Materials Science and Process Technology), Stephen M. Rossnagel et al. Noyes Publications (January 1, 1990) ISBN-10: 0815512201; ISBN-13: 978-0815512202,
- Physics of Semiconductor Devices par by Simon M. Sze, Wiley-Interscience; 2 edition (September 1981), ISBN-10: 0471056618, ISBN-13: 978-0471056614,
- Plasma etching and reactive ion etching (American Vacuum Society monograph series) par J. W Coburn, American Institute of Physics (1982) ISBN-10: 0883184060; ISBN-13: 978-0883184066.

## Revendications

1. Procédé de fabrication d'un moule d'impression en trois dimensions comportant au moins :
a) la formation d'au moins une tranchée (73, 73'), de largeur W et de profondeur h, dans un substrat (2), formant ainsi trois types de surfaces :
- des fonds (70) de la tranchée,
- des flancs (71) de la tranchée,
- la surface restante du substrat, dit sommet (72) du substrat,
b) la formation dans ces tranchées de couches alternées (4(i), i=1...n)), uniquement perpendiculairement au substrat et au fond (70) des tranchées, d'un premier matériau et d'un deuxième matériau pouvant être gravé sélectivement par rapport au premier matériau,
c) puis une gravure sélective desdites couches perpendiculaires au substrat, formant ainsi une topologie comportant au moins :
- des premiers motifs (5) dont le sommet est à un premier niveau par rapport à une surface du substrat (2) située de part et d'autre de ladite topologie, ces premiers motifs (5) étant en premier matériau,
- et des deuxièmes motifs (6) ayant au moins un deuxième niveau par rapport à ladite surface du substrat, différent du premier niveau et inférieur à celui-ci, ces deuxièmes motifs (6) étant en deuxième matériau.

2. Procédé selon la revendication 1 :
- la gravure sélective gravant en outre au moins une partie du substrat (2), de part et d'autre de la topologie les premiers motifs étant alors saillants par rapport à la surface du substrat ;
- ou la gravure gravant préférentiellement le deuxième matériau, le sommet des premiers motifs étant, après gravure sélective, d'un niveau sensiblement égal à celui de la surface du substrat ;
- ou comportant, avant l'étape c), une gravure anisotrope du premier et du deuxième matériau, puis une gravure sélective du deuxième matériau, le sommet des premiers motifs étant, après gravure sélective, d'un niveau inférieur à celui de la surface du substrat.

3. Procédé selon l'une des revendications 1 ou 2, un matériau (9, 90) limitant ou inhibant la formation des couches alternées sur le fond du substrat, étant formé en fond (70) des tranchées (73) .

4. Procédé selon l'une des revendications 1 à 3, le substrat étant de type SOI, comportant une couche de matériau semi-conducteur superficielle (20), une couche isolante enterrée (9) et un substrat support (2), une portion de ladite couche isolante enterrée formant couche (9) de matériau limitant ou inhibant la formation des couches alternées sur le fond du substrat en fond (70) de tranchées (73), et étant obtenue en gravant ladite couche (20) superficielle jusqu'à la couche isolante enterrée (9).

5. Procédé selon la revendication 4, ledit matériau (90) limitant ou inhibant le dépôt des couches alternées (4(i)) étant en outre formé sur le sommet (72) du substrat, les couches alternées étant alors déposées uniquement dans les tranchées, un amincissement étant effectué ultérieurement de façon à mettre à nu le champ du substrat.

6. Procédé selon l'une des revendications 1 à 4, comportant en outre une formation desdites couches alternées sur le sommet (72) du substrat (2), celles-ci étant alors déposées au moins suivant les flancs (71) des tranchées et autour de chaque tranchée, sur le champ du substrat, un amincissement étant effectué ultérieurement de façon à mettre à nu le champ du substrat.

7. Procédé selon l'une des revendications 1 à 6, au moins une tranchée (73) n'étant pas entièrement remplie par les couches alternées (4(i)), laissant ainsi subsister une portion de tranchée résiduelle, un matériau de remplissage (3) étant déposé au moins dans cette portion de tranchée résiduelle (9).

8. Procédé selon l'une des revendications 1 à 7, la gravure sélective étant une gravure partielle du deuxième matériau, le fond (70) des deuxièmes motifs étant composé du deuxième type de matériau, gravé préférentiellement par rapport au premier.

9. Procédé selon l'une des revendications 1 à 8, les deuxièmes motifs étant en un matériau présentant une différence de vitesse de gravure d'un deuxième motif à l'autre, ce qui résulte, après gravure, en la formation de deuxièmes motifs avec au moins deux niveaux différents.

10. Procédé selon la revendication 9, la différence de vitesse de gravure entre au moins deux couches des deuxièmes motifs étant obtenue par différence de composition du matériau entre au moins ces deux couches.

11. Procédé selon l'une des revendications 1 à 10, le premier matériau étant en Si et le deuxième matériau étant en SiGex avec x>15%.

12. Dispositif formant moule d'impression en trois dimensions et comportant au moins
- un substrat, comportant au moins une tranchée et une alternance de couches (4(i), i=1...n)) dans cette tranchée, uniquement perpendiculairement au substrat et au fond (70) des tranchées, d'un premier matériau et d'un deuxième matériau qui peut être gravé sélectivement par rapport au premier matériau,
- une topologie de surface comportant au moins :
a) des premiers motifs (5) en premier matériau dont les sommets sont ceux des couches en premier matériau et sont à un premier niveau par rapport à une surface du substrat (2), située de part et d'autre de ladite topologie,
b) et des deuxièmes motifs (6) en deuxième matériau dont les sommets sont ceux des couches en deuxième matériau et sont à au moins un deuxième niveau par rapport à ladite surface du substrat, différent du premier niveau et inférieur à celui-ci.

13. Dispositif selon la revendication 12:
- les premiers motifs étant saillants par rapport à ladite surface du substrat (2) et étant en un matériau différent de celui du substrat,
- ou le premier niveau étant sensiblement voisin de ladite surface du substrat,
- ou les premiers motifs étant à un niveau inférieur à ladite surface du substrat (2).

## Patentansprüche

1. Verfahren zum Herstellen einer dreidimensionalen Druckform, das zumindest umfasst:
a) Ausbilden zumindest eines Grabens (73, 73') mit der Breite W und der Tiefe h in einem Substrat (2), wobei drei Arten von Flächen geschaffen werden:
- Grabenböden (70),
- Grabenflanken (71),
- restliche Substratfläche, Substratscheitel (72) genannt,
b) Ausbilden von abwechselnden Schichten (4(i), i = 1 ... n)) in diesen Gräben nur senkrecht zum Substrat und zum Grabenboden (70), und zwar aus einem ersten Material und einem zweiten Material, das selektiv bezüglich des ersten Materials geätzt sein kann,
c) dann selektives Ätzen der Schichten senkrecht zum Substrat, wodurch eine Topologie gebildet wird, die zumindest umfasst:
- erste Muster (5), deren Scheitel auf einer ersten Höhe bezüglich einer Fläche des Substrats (2) liegt, die auf beiden Seiten des Topologie liegt, wobei diese ersten Muster (5) aus dem ersten Material bestehen,
- und zweite Muster (6), die zumindest eine zweite Höhe bezüglich der Fläche des Substrats haben, die sich von der ersten Höhe unterscheidet und geringer als diese ist, wobei diese zweiten Muster (6) aus dem zweiten Material bestehen.

2. Verfahren nach Anspruch 1,
- wobei mit dem selektiven Ätzen ferner zumindest ein Teil des Substrats (2) auf beiden Seiten der Topologie geätzt wird, wobei die ersten Muster dann bezüglich der Oberfläche des Substrats vorspringen;
- oder mit dem Ätzen vorzugsweise das zweite Material geätzt wird, wobei der Scheitel der ersten Muster nach dem selektiven Ätzen auf einer Höhe liegen, die im Wesentlichen gleich der der Oberfläche des Substrats ist;
- oder wobei vor Schritt c) ein anisotropes Ätzen des ersten und des zweiten Materials erfolgt, dann ein selektives Ätzen des zweiten Materials, wobei der Scheitel der ersten Muster nach dem selektiven Ätzen auf einer geringeren Höhe als die Oberfläche des Substrats liegt.

3. Verfahren nach einem der Ansprüche 1 oder 2, wobei ein Material (9, 90), das die Bildung von abwechselnden Schichten am Boden des Substrats einschränkt bzw. hemmt, am Boden (70) der Gräben (73) ausgebildet ist.

4. Verfahren nach einem der Ansprüche 1 bis 3, wobei das Substrat vom Typ SOI ist, das eine Oberflächenschicht (20) aus Halbleitermaterial, eine vergrabene Isolierschicht (9) und ein Trägersubstrat (2) enthält, wobei ein Abschnitt der vergrabenen Isolierschicht eine Schicht (9) aus einem Material bildet, das die Bildung von abwechselnden Schichten auf dem Boden des Substrats am Boden (70) der Gräben (73) einschränkt bzw. hemmt, und durch Ätzen der Oberflächenschicht (20) bis auf die vergrabene Isolierschicht (9) erhalten wird.

5. Verfahren nach Anspruch 4, wobei das Material (90), das die Aufbringung von abwechselnden Schichten (4(i)) einschränkt bzw. hemmt, ferner am Scheitel (72) des Substrats ausgebildet wird, wobei die abwechselnden Schichten dann nur in den Gräben aufgebracht werden, wobei dann nachträglich eine Verjüngung erfolgt, so dass das Feld des Substrats freigelegt wird.

6. Verfahren nach einem der Ansprüche 1 bis 4, ferner umfassend ein Ausbilden der abwechselnden Schichten am Scheitel (72) des Substrats (2), wobei diese dann zumindest entlang der Grabenflanken (71) und um jeden Graben herum auf das Feld des Substrats aufgebracht werden, wobei dann nachträglich eine Verjüngung erfolgt, so dass das Feld des Substrats freigelegt wird.

7. Verfahren nach einem der Ansprüche 1 bis 6, wobei zumindest ein Graben (73) nicht vollständig von den abwechselnden Schichten (4(i)) ausgefüllt wird, wobei so ein restlicher Grabenabschnitt bestehen bleibt, wobei ein Füllmaterial (3) zumindest in diesem restlichen Grabenabschnitt (9) aufgebracht wird.

8. Verfahren nach einem der Ansprüche 1 bis 7, wobei das selektive Ätzen ein Teilätzen des zweiten Materials ist, wobei der Boden (70) der zweiten Muster aus dem zweiten Typ von Material besteht, das vorzugsweise bezüglich des ersten geätzt wird.

9. Verfahren nach einem der Ansprüche 1 bis 8, wobei die zweiten Muster aus einem Material bestehen, das eine Differenz in der Ätzgeschwindigkeit von einem zweiten Muster zum anderen aufweist, wodurch sich nach dem Ätzen die Bildung von zweiten Mustern mit zumindest zwei unterschiedlichen Höhen ergibt.

10. Verfahren nach Anspruch 9, wobei die Differenz in der Ätzgeschwindigkeit zwischen zumindest zwei Schichten der zweiten Muster durch eine Differenz in der Materialzusammensetzung zwischen zumindest diesen beiden Schichten erhalten wird.

11. Verfahren nach einem der Ansprüche 1 bis 10, wobei das erste Material aus Si und das zweite Material aus SiGex mit x > 15 % besteht.

12. Dreidimensionale Druckformvorrichtung, zumindest enthaltend:
- ein Substrat, das zumindest einen Graben und eine Wechselfolge von Schichten (4(i), i = 1 ... n) in diesem Graben nur senkrecht zum Substrat und zum Boden (70) der Gräben aufweist, und zwar aus einem ersten Material und einem zweiten Material, das selektiv bezüglich des ersten Materials geätzt sein kann,
- eine Oberflächentopologie, zumindest umfassend:
a) erste Muster (5) aus einem ersten Material, deren Scheitel diejenigen der Schichten aus erstem Material sind und auf einer ersten Höhe bezüglich einer Oberfläche des Substrats (2) liegt, die auf beiden Seiten der Topologie liegt,
b) zweite Muster (6) aus einem zweiten Material, deren Scheitel diejenigen der Schichten aus zweitem Material sind und auf einer zweiten Höhe bezüglich der Oberfläche des Substrats liegen, die sich von der ersten Höhe unterscheidet und geringer als diese ist.

13. Vorrichtung nach Anspruch 12,
- wobei die ersten Muster bezüglich der Oberfläche des Substrats (2) vorspringen und aus einem Material bestehen, das sich von dem des Substrats unterscheidet,
- oder die erste Höhe im Wesentlichen nahe bei der Oberfläche des Substrats liegt,
- oder die ersten Muster in einer geringeren Höhe als die Oberfläche des Substrats (2) liegen.

## Claims

1. Method to fabricate an imprint mould in three dimensions comprising at least:
a) forming at least one trench (73, 73'), of width W and depth h, in a substrate (2), thereby forming three types of surfaces:
- bottoms (70) of the trench,
- sidewalls (71) of the trench,
- the remaining surface of the substrate, called top (72) of the substrate,
b) forming alternate layers (4(i), i=1...n)) in these trenches, solely perpendicularly to the substrate and to the bottoms (70) of the trenches, in a first material and in a second material which can be selectively etched relative to the first material,
c) then selectively etching said layers perpendicular to the substrate, thereby forming a topology comprising at least:
- first patterns (5) whose top lies at a first level relative to a surface of the substrate (2), located either side of said topology, these first patterns (5) being in a first material,
- and second patterns (6) having at least a second level relative to said surface of the substrate, different from and lower than the first level, these second patterns (6) being in a second material.

2. Method according to claim 1:
- the selective etching also etching at least part of the substrate (2), either side of the topology, the first patterns then protruding relative to the surface of the substrate,
- or the etching preferably etching the second material, the top of the first patterns, after selective etching, lying at a level substantially equal to the level of the surface of the substrate;
- or comprising, before step c), anisotropic etching of the first and second material, then selective etching of the second material, the top of the first patterns after selective etching being at a lower level than the level of the surface of the substrate.

3. Method according to one of claims 1 or 2, a material (9, 90) limiting or inhibiting the formation of alternate layers on the bottom of the substrate being formed at the bottom (70) of the trenches (73).

4. Method according to either of claims 1 to 3, the substrate being of SOI type, comprising a surface layer of semiconductor material (20), a buried insulator layer (9) and a carrier substrate (2), one portion of said buried insulator layer forming a layer (9) of material limiting or inhibiting the formation of alternate layers on the bottom of the substrate at the bottom (70) of trenches, and being obtained by etching said surface layer (20) as far as the buried insulator layer (9).

5. Method according to claim 4, said material (90) limiting or inhibiting the deposit of alternate layers (4(i)) also being formed on the top (72) of the substrate, the alternate layers then being deposited solely in the trenches, thinning being performed subsequently so as to expose the field of the substrate.

6. Method according to any of claims 1 to 4, further comprising the forming of said alternate layers on the top (72) of the substrate (2), these layers then being deposited at least following the sidewalls (71) of the trenches and around each trench, on the field of the substrate, thinning then being performed subsequently to expose the field of the substrate.

7. Method according to any of claims 1 to 6, at least one trench (73) not being fully filled with the alternate layers (4(i)), thereby leaving a residual trench portion to subsist, a filler material (3) being deposited at least in this residual trench portion (9).

8. Method according to any of claims 1 to 7, the selective etching being partial etching of the second material, the bottom (70) of the second patterns consisting of the second type of material preferably etched relative to the first.

9. Method according to any of claims 1 to 8, the second patterns being in a material having difference in etch speed from one second pattern to another which, after etching, results in the formation of second patterns with at least two different levels.

10. Method according to claim 9, the difference in etch speed between at least two layers of second patterns being obtained by a difference in composition of material between at least these two layers.

11. Method according to any of claims 1 to 10, the first material being in Si and the second material being in SiGex with x>15%.

12. Device forming an imprint mould in three dimensions and comprising at least:
- a substrate, comprising at least one trench and alternating layers (4(i), i=1...n)) in this trench, solely perpendicularly to the substrate and to the bottoms (70) of the trenches, in a first material and a second material which can be selectively etched relative to the first type of material,
- a surface topology comprising at least:
a) first patterns (5) in first material whose tops are those of the layers in a first material, and lie at a first level relative to a surface of the substrate (2) located either side of said topology,
b) and second patterns (6) in second material whose tops are those of the layers in a second material, and lie at least at a second level relative to said surface of the substrate, different from and lower than the first level.

13. Device according to claim 12:
- the first patterns protruding relative to said surface of the substrate (2) and being in a material different from the substrate material;
- or the first level being substantially adjacent to said surface of the substrate;
- or the first patterns being at a level lower than said surface of the substrate (2).
